(19) Europäisches Patentamt
European Patent Office
Office européen des brevets

(11) EP 3 506 358 B1

(12) FASCICULE DE BREVET EUROPEEN

(45) Date de publication et mention
de la délivrance du brevet:
**06.01.2021 Bulletin 2021/01**

(51) Int Cl.:
***H01L 27/16*** *(2006.01)*      ***H01L 35/32*** *(2006.01)*
***H01L 35/34*** *(2006.01)*

(21) Numéro de dépôt: **18214808.0**

(22) Date de dépôt: **20.12.2018**

(54) **DISPOSITIF THERMOELECTRIQUE A JONCTION THERMOELECTRIQUE FORMEE DANS L'EPAISSEUR D'UN SUBSTRAT ET PROCEDE DE FABRICATION DU DISPOSITIF THERMOELECTRIQUE**

THERMOELEKTRISCHE VORRICHTUNG MIT THERMOELEKTRISCHEM ÜBERGANG, DER IN DER DICKE EINES SUBSTRATS AUSGEBILDET IST, UND HERSTELLUNGSVERFAHREN DIESER THERMOELEKTRISCHEN VORRICHTUNG

THERMOELECTRIC DEVICE WITH THERMOELECTRIC JUNCTION FORMED IN THE THICKNESS OF A SUBSTRATE AND METHOD FOR MANUFACTURING SUCH A THERMOELECTRIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2017 FR 1763341**

(43) Date de publication de la demande:
**03.07.2019 Bulletin 2019/27**

(73) Titulaire: **Commissariat à l'Énergie Atomique et aux Énergies Alternatives
75015 Paris (FR)**

(72) Inventeurs:
• **SAVELLI, Guillaume
38180 SEYSSINS (FR)**
• **COLONNA, Jean-Philippe
38700 CORENC (FR)**

(74) Mandataire: **INNOV-GROUP
310, avenue Berthelot
69372 Lyon Cedex 08 (FR)**

(56) Documents cités:
**CN-A- 106 486 593      US-A1- 2014 021 576**

## Description

## Domaine technique de l'invention

Le domaine technique de l'invention concerne les dispositifs thermoélectriques, et plus particulièrement de type générateur d'énergie électrique à partir d'une différence de température appliquée au dispositif thermoélectrique concerné, ou de type à effet Peltier.

## Etat de la technique

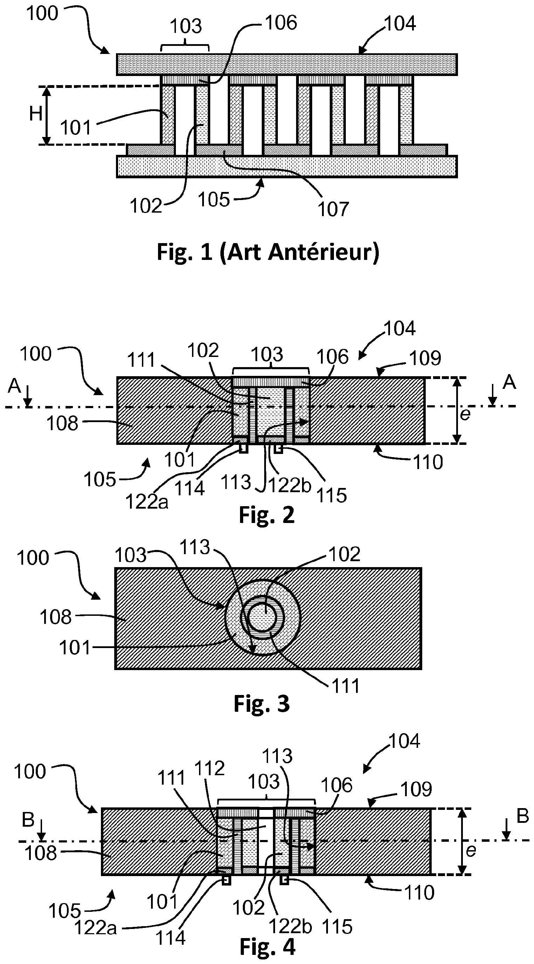

De manière connue, et comme illustré en figure 1, un dispositif thermoélectrique 100 peut comporter un ensemble de premiers éléments 101 en matériau thermoélectrique et un ensemble de second éléments 102 en matériau thermoélectrique différent du matériau thermoélectrique des premiers éléments 101. Notamment, dans le domaine, les premier et second éléments sont aussi appelés élément N et élément P, un élément N est un élément à conductivité de type N : c'est-à-dire que le matériau qui le compose est à coefficient Seebeck strictement négatif, et un élément P est un élément à conductivité de type P : c'est-à-dire que le matériau qui le compose est à coefficient Seebeck strictement positif. Les premiers et seconds éléments 101, 102 sont reliés électriquement pour former des jonctions thermoélectriques 103 entre un premier côté 104, par exemple dit côté chaud, du dispositif thermoélectrique 100 et un deuxième côté 105, par exemple dit côté froid, du dispositif thermoélectrique 100. Chaque jonction thermoélectrique 103 comporte un des premiers éléments 101 et un des seconds éléments 102. Pour chaque jonction thermoélectrique 103, un élément de liaison électrique 106 (aussi appelé connecteur de premier et second éléments 101, 102) permet de lier électriquement le premier élément 101 et le second élément 102 de la jonction thermoélectrique 103 correspondante, aussi appelée jonction NP dans le domaine. Des éléments de connexion 107 (aussi appelés connecteurs de jonctions thermoélectriques) permettent de relier électriquement, notamment en série, des jonctions thermoélectriques 103 entre elles. Le dispositif thermoélectrique 100 de la figure 1 est composé de plusieurs premiers et seconds éléments 101, 102 reliés électriquement en série et thermiquement en parallèle pour former quatre jonctions thermoélectriques 103.

De manière générale, en considérant que les dimensions (notamment hauteur et section) des premiers et seconds éléments 101, 102 sont identiques, les performances électriques du dispositif thermoélectrique 100 utilisé en tant que générateur d'énergie, notamment d'énergie électrique, peuvent être données de manière simplifiée par :

- une résistance électrique interne, notée $R_{int}$, par exemple déterminée de la manière suivante $R_{int} = N \times \rho_{np} \times H / A$ (notée équation (1) par la suite), avec $N$ le nombre de jonctions thermoélectriques 103 du dispositif thermoélectrique 100, $H$ la hauteur du premier élément 101 d'une des jonctions thermoélectriques 103 du dispositif thermoélectrique 100, cette hauteur $H$ étant mesurée selon un axe orthogonal au premier premier côté 104 et au deuxième côté 105, $A$ l'aire de la section dudit premier élément 101 prise orthogonalement à la direction dans laquelle est mesurée $H$, et $\rho_{np}$ correspondant à la résistivité électrique dudit premier élément 101 (cette résistivité électrique étant considérée comme identique pour chaque premier élément 101 et chaque second élément 102 du dispositif thermoélectrique 100) ;

- une tension de sortie notée $V_{oc}$ et pouvant déterminée de la manière suivante $V_{oc} = N \times S_{np} \times \Delta T$ (notée équation (2) par la suite), avec $S_{np}$ le coefficient Seebeck associé à l'une des jonctions thermoélectriques 103 du dispositif thermoélectrique et donné par $S_{np} = (S_p - S_n)$, $\Delta T$ la différence de température effective entre le premier côté 104 et le deuxième côté 105 à laquelle les jonctions thermoélectriques sont soumises, $N$ le nombre de jonctions thermoélectriques 103 du dispositif thermoélectrique 100, $S_p$ le coefficient Seebeck du matériau de type P utilisé pour former par exemple chaque second élément 102, et $S_n$ le coefficient Seebeck du matériau de type N utilisé pour former par exemple chaque premier élément 101 ;

- une puissance électrique utile $P_u$ avec

$$P_u = \frac{V_{oc}^2}{4 \times R_{int}}$$ (notée équation (3) par la suite).

L'équation (1) néglige les résistances de contact et les résistances des connexions métalliques (éléments de connexion 107 et éléments de liaison 106) qui ont généralement des contributions négligeables devant les résistances des éléments N et P. Par « résistance » on entend la résistance électrique.

L'architecture du dispositif thermoélectrique 100 représenté en figure 1 est de type technologie 3D (pour trois dimensions) car elle permet, dans le cadre de la génération d'énergie électrique par le dispositif thermoélectrique, d'exploiter une source chaude (placée côté chaud) et une source froide (placée côté froid) agencées de manière opposée selon la direction de mesure de la hauteur de chacun des premiers et seconds éléments 101, 102. Une source froide présente une température strictement inférieure à la température que présente la source chaude. Autrement dit, les sources chaude et froide peuvent s'étendre de part et d'autre d'une plaque (ou substrat), selon son épaisseur, dans laquelle les jonctions thermoélectriques sont formées. Une telle architecture a l'avantage de présenter une résistance électrique faible du fait que la hauteur $H$ de chacun des premiers et seconds éléments 101, 102 est généralement de quelques micromètres (par exemple cette hauteur peut être comprise entre $1\mu m$ et $100\mu m$) dans le domaine de la microélectronique.

On comprend des équations (1) à (3) ci-dessus qu'il existe un besoin d'élaborer une solution permettant d'améliorer l'intégration d'une jonction thermoélectrique au sein d'un dispositif thermoélectrique, notamment pour en réduire l'encombrement.

Par ailleurs, dans le cadre d'un dispositif thermoélectrique obtenu par des techniques de la microélectronique, il existe un besoin de miniaturiser ce dispositif thermoélectrique, ceci passant par une amélioration de l'intégration de la jonction thermoélectrique au sein du dispositif thermoélectrique.

Un dispositif thermoélectrique 100 peut fonctionner en mode générateur électrique, aussi appelé mode Seebeck, ou en mode refroidisseur, aussi appelé mode Peltier. En fait, en mode Seebeck, le dispositif thermoélectrique 100 permet d'exploiter une différence de température induisant un gradient thermique aux bornes de chacune des jonctions thermoélectriques pour permettre la génération d'énergie électrique, comme une tension, par les jonctions thermoélectriques. Les bornes d'une jonction thermoélectrique correspondent à ses deux extrémités géométriques opposées respectivement proximale du premier côté 104 et proximale du deuxième côté 105. En mode Peltier, le dispositif thermoélectrique 100 peut être alimenté en énergie électrique de sorte à refroidir l'un de ses côtés

(premier côté 104 ou deuxième côté 105), cette alimentation électrique alimente alors les jonctions thermoélectriques qui permettent le refroidissement recherché.

Les demandes de brevet publiées sous les numéros US 2014/0021576 A1 et CN 106 486 593 A décrivent un dispositif thermoélectrique.

**Objet de l'invention**

L'invention a pour but d'améliorer l'intégration d'au moins une jonction thermoélectrique au sein d'un dispositif thermoélectrique. Cette intégration est notamment telle qu'elle permet d'augmenter la densité de jonctions thermoélectriques au sein du dispositif thermoélectrique, et/ou selon certains cas de diminuer sa résistance électrique interne et/ou d'autoriser la formation d'un passage au travers d'un substrat logeant la jonction thermoélectrique.

On tend vers ce but grâce à un dispositif thermoélectrique comportant :

- un substrat comportant des première et deuxième faces opposées selon une épaisseur dudit substrat,
- au moins une jonction thermoélectrique comportant un premier élément et un second élément reliés électriquement entre eux en vue de générer un effet thermoélectrique,

les premier et second éléments étant agencés dans le substrat et étant reliés électriquement à leurs extrémités situées du côté de la première face du substrat, le premier élément adoptant la forme d'une couche.

Un avantage d'une telle forme du premier élément est qu'il permet de faciliter l'intégration de la jonction thermoélectrique dans le substrat, par exemple le premier élément peut alors entourer le second élément, ou peut autoriser en son sein la formation du passage permettant la formation d'une liaison électrique entre des dispositifs électroniques disposés de part et d'autre du substrat.

Selon la présente invention, le dispositif thermoélectrique comporte au moins un ensemble de jonctions thermoélectriques reliées électriquement en série et comprenant chacune un premier élément et un second élément, lesdites jonctions thermoélectriques dudit ensemble étant agencées de telle sorte que :

- l'une des jonctions thermoélectriques dudit ensemble est une première jonction thermoélectrique correspondant à ladite jonction thermoélectrique dont le premier élément adopte la forme d'une couche,
- l'une des jonctions thermoélectriques dudit ensemble est une deuxième jonction thermoélectrique entourée par la première jonction thermoélectrique.

Le dispositif thermoélectrique peut comporter une ou plusieurs des caractéristiques suivantes :

- le premier élément est creux, et le second élément est entouré par le premier élément ;
- le second élément est creux ;
- la jonction thermoélectrique est formée au travers du substrat selon son épaisseur ;
- le substrat est muni d'un trou débouchant reliant les première et deuxième faces du substrat, au moins les premier et second éléments de la jonction thermoélectrique étant agencés dans ledit trou débouchant ;
- la couche formant le premier élément de la jonction thermoélectrique s'étend contre une paroi du trou débouchant ;
- le substrat est dopé électriquement d'un type choisi entre P ou N, et l'un des premier et second éléments est dans un matériau identique à celui du substrat ;
- le second élément de la deuxième jonction thermoélectrique est entouré par le premier élément de la deuxième jonction thermoélectrique ;
- l'ensemble de jonctions thermoélectriques comporte au moins une troisième jonction thermoélectrique, la troisième jonction thermoélectrique étant entourée par la première jonction thermoélectrique, et la troisième jonction thermoélectrique entourant la deuxième jonction thermoélectrique ;
- le dispositif thermoélectrique comporte un passage agencé au travers du substrat et entouré par les premier et second éléments de la jonction thermoélectrique ;
- les premier et second éléments de la jonction thermoélectrique se présentent chacun sous la forme d'une couche de sorte à délimiter deux cylindres creux coaxiaux et d'axes sensiblement parallèles à la direction de mesure de l'épaisseur du substrat.

L'invention est aussi relative à un dispositif de génération d'une première énergie comportant au moins un dispositif thermoélectrique tel que décrit, le dispositif thermoélectrique étant configuré de sorte à exploiter une deuxième énergie pour générer la première énergie.

Selon un mode de réalisation du dispositif de génération de la première énergie, il peut comporter un premier dispositif électronique et un deuxième dispositif électronique, le dispositif thermoélectrique étant placé entre les premier et deuxième dispositifs électroniques de telle sorte que le premier dispositif électronique forme une source chaude pour le dispositif thermoélectrique, et le dispositif thermoélectrique comporte un passage entouré par les premier et second éléments de la jonction thermoélectrique, le passage étant agencé au travers du substrat, au moins un lien électrique relie électriquement le premier dispositif électronique au deuxième dispositif électronique en passant par le passage.

L'invention est aussi relative à un procédé de fabrication d'un dispositif thermoélectrique tel que décrit, ledit procédé de fabrication comportant une étape de fourniture du substrat, et une étape de formation de ladite au moins une jonction thermoélectrique telle que le premier élément de la jonction thermoélectrique adopte la forme d'une couche.

Selon un premier mode de réalisation du procédé de fabrication, le substrat fourni comporte un trou débouchant ayant une paroi reliant la première face du substrat à la deuxième face du substrat, et l'étape de formation de ladite au moins une jonction thermoélectrique comporte :

- une étape de formation d'une première couche en un premier matériau, la première couche s'étendant au moins dans le trou débouchant pour former, dans le trou débouchant, le premier élément de la jonction thermoélectrique,
- une étape de formation d'une deuxième couche en matériau diélectrique à partir de la première couche, la deuxième couche s'étendant au moins dans le trou débouchant,
- une étape de gravure de la deuxième couche sorte à en retirer une portion située dans le trou débouchant pour libérer une portion de la première couche,
- une étape de dépôt d'un deuxième matériau, au moins dans le trou débouchant, de telle sorte que :

  ○ le deuxième matériau déposé forme, dans le trou débouchant, le second élément de la jonction thermoélectrique,
  ○ le deuxième matériau déposé est en contact, d'une part, avec la deuxième couche et, d'autre part, avec la portion de la première couche.

Selon un deuxième mode de réalisation du procédé de fabrication, ce deuxième mode de réalisation ne faisant pas partie de la présente invention, le substrat est en un premier matériau présentant un premier coefficient Seebeck, et l'étape de formation de ladite au moins une jonction thermoélectrique est telle que l'un des premier et second éléments de la jonction thermoélectrique est formé par une partie du substrat, et que l'autre des premier et second éléments de la jonction thermoélectrique est formé par un deuxième matériau présentant un deuxième coefficient Seebeck de signe opposé au premier coefficient Seebeck, le deuxième matériau étant déposé dans une cavité formée dans le substrat.

**Description sommaire des dessins**

L'invention sera mieux comprise à la lecture de la description détaillée qui va suivre d'au moins un mode de réalisation particulier de l'invention, donnée uniquement à titre d'exemple non limitatif et faite en se référant aux dessins dans lesquels : La figure 1 illustre, selon une vue en coupe, un dispositif thermoélectrique selon l'art antérieur ;

- La figure 2 illustre, selon une vue en coupe, un mode de réalisation d'un dispositif thermoélectrique selon l'invention ;
- La figure 3 est une vue du dispositif thermoélectrique de la figure 2 selon la coupe A-A perpendiculaire au plan de la figure 2 ;
- La figure 4 illustre, selon une vue en coupe, un autre mode de réalisation d'un dispositif thermoélectrique selon l'invention ;
- La figure 5 est une vue du dispositif thermoélectrique de la figure 4 selon la coupe B-B perpendiculaire au plan de la figure 4 ;
- La figure 6 illustre, selon une vue en coupe, une amélioration du mode de réalisation de la figure 4 ;
- La figure 7 est une vue du dispositif thermoélectrique de la figure 6 selon la coupe C-C perpendiculaire au plan de la figure 6 ;
- La figure 8 illustre, selon une vue en coupe, une amélioration du mode de réalisation de la figure 2 ;
- La figure 9 est une vue du dispositif thermoélectrique de la figure 8 selon la coupe D-D perpendiculaire au plan de la figure 8 ;
- La figure 10 illustre, selon une vue en coupe, une réalisation du dispositif thermoélectrique selon l'invention à trois jonctions thermoélectriques formées dans un même trou ;
- Les figures 11 à 19 illustrent un premier mode de réalisation d'un procédé de fabrication du dispositif thermoélectrique ;
- Les figures 20 à 29 illustrent un deuxième mode de réalisation d'un procédé de fabrication du dispositif thermoélectrique ;
- La figure 30 illustre une utilisation d'un dispositif thermoélectrique selon l'invention au sein d'un dispositif de génération d'énergie ;

- La figure 31 illustre une réalisation particulière dans laquelle plusieurs dispositifs thermoélectriques selon l'invention sont empilés ;
- La figure 32 illustre selon une vue de dessus différentes implémentations d'ensembles de jonctions thermoélectriques selon l'invention dans un même substrat.

Dans ces figures, les mêmes références sont utilisées pour désigner les mêmes éléments.

Par ailleurs, les éléments représentés sur les figures ne sont pas nécessairement à l'échelle pour en simplifier leur compréhension.

## Description détaillée

Selon une réalisation de l'invention, comme illustré par exemple en figures 2 à 5, le dispositif thermoélectrique 100 comporte au moins une jonction thermoélectrique 103. Cette jonction thermoélectrique 103 comporte un premier élément 101 et un second élément 102 reliés électriquement entre eux en vue de générer un effet thermoélectrique, notamment en fonctionnement dudit dispositif thermoélectrique 100. La liaison électrique entre les premier et second éléments 101, 102 peut être réalisée par un élément de liaison 106 (aussi appelé connecteur) électriquement conducteur. Le dispositif thermoélectrique 100 comporte un substrat 108 comportant des première et deuxième faces 109, 110 opposées selon une épaisseur e du substrat 108. En particulier, la jonction thermoélectrique 103 est logée/agencée dans le substrat 108 selon son épaisseur, elle peut alors s'étendre entre les première et deuxième faces 109, 110. Les premier et second éléments 101, 102 de la jonction thermoélectrique 103 sont agencés dans le substrat 108. Le premier élément 101 de la jonction thermoélectrique 103 adopte la forme d'une couche. Les premier et second éléments 101, 102 sont reliés électriquement à leurs extrémités situées du côté de la première face 109 du substrat 108, c'est-à-dire notamment à leurs extrémités proximales de la première face 109. De préférence, les premier et second éléments 101, 102 présentent chacun une extrémité, opposée aux extrémités des premier et second éléments 101, 102 reliées électriquement entre elles, située du côté de la deuxième face 110 du substrat 108, et notamment distale de la première face 109 du substrat 108. Autrement dit, le premier élément 101 et le second élément 102 peuvent comporter chacun une première extrémité proximale de la première face 109 et une deuxième extrémité proximale de la deuxième face 110, ces première et deuxième extrémités étant opposées selon l'épaisseur du substrat 108. Pour une jonction thermoélectrique 103, les premières extrémités des premier et second éléments 101, 102 sont reliées électriquement, et les deuxièmes extrémités des premier et second éléments 101, 102 peuvent le cas échéant être reliées à une autre jonction thermoélectrique ou à des bornes de connexion. La forme de couche du premier élément 101 permet d'améliorer l'intégration de la jonction thermoélectrique 103 au sein du substrat 108 car cela autorise de placer le premier élément 101 au plus proche du second élément 102 pour une même jonction thermoélectrique 103 en utilisant par exemple des techniques de dépôt de couches minces de la microélectronique. La couche formant le premier élément 101 peut présenter (de préférence lorsqu'elle est en polysilicium dopé) une épaisseur comprise entre 200nm et 5$\mu$m, de préférence comprise entre 1$\mu$m et 5$\mu$m, et par exemple égale à 2$\mu$m. L'épaisseur de la couche formant le premier élément 101 est mesurée sensiblement orthogonalement à la direction de mesure de l'épaisseur du substrat 108, cette épaisseur de ladite couche est notamment choisie pour limiter les coûts et pour que le premier élément 101 ne soit pas trop résistif électriquement parlant. Selon une autre formulation, le premier élément 101 de la jonction thermoélectrique 103 adoptant la forme d'une couche est de préférence tel que l'épaisseur de cette couche est donnée dans le plan du substrat 108, c'est-à-dire selon une direction sensiblement orthogonale à la direction donnant l'épaisseur e du substrat 108. Le premier élément 101 peut border le second élément 102, notamment avec interposition d'un matériau diélectrique 111 permettant de séparer les premier et second éléments 101, 102, notamment à l'exception de leurs extrémités reliées électriquement qui peuvent, le cas échéant, être en contact. Alternativement, la liaison électrique entre les premier et second éléments 101, 102 peut être assurée par l'élément de liaison 106, de préférence en siliciure comportant notamment du titane. Cet élément de liaison 106 peut être formé par deux portions en siliciure formées respectivement dans le prolongement des premier et second éléments 101, 102. L'élément de liaison 106 peut présenter une épaisseur, mesurée selon l'épaisseur du substrat 108, comprise entre 10nm et 1$\mu$m. Notamment, chaque portion en siliciure peut appartenir à l'un des premier et second éléments 101, 102, ainsi les premier et second éléments 101, 102 peuvent comporter chacun une portion en siliciure, et ces portions en siliciures sont en contact pour assurer la liaison électrique entre les premier et second éléments 101, 102 de la jonction thermoélectrique 103. En particulier, les portions en siliciure peuvent avoir été obtenues par siliciuration des premières extrémités des premier et second éléments 101, 102. Plus précisément, la jonction thermoélectrique 103 est notamment formée, c'est-à-dire agencée, au travers du substrat 108 selon son épaisseur, ceci permettant de profiter de l'épaisseur du substrat 108 pour exploiter ou obtenir une différence de température satisfaisante de part et d'autre du substrat 108 qui peut alors faire office de barrière thermique pour améliorer cette différence de température de part et d'autre du substrat 108. L'utilisation d'une couche pour former le premier élément 101 permet, par ailleurs, de disposer d'un gradient thermique le plus élevé possible aux bornes de la jonction thermoélectrique 103 tout en limitant la résistance interne de la jonction thermoélectrique 103, et donc au final tout en limitant la résistance interne du dispositif thermoélectrique 100.

Dans la présente description, par « compris entre deux valeurs », on entend que ces valeurs sont incluses.

Le dispositif thermoélectrique 100 peut comporter une ou plusieurs jonctions thermoélectriques 103. Ainsi, tout ce qui s'applique à une jonction thermoélectrique 103 peut s'appliquer à tout ou partie des jonctions thermoélectriques 103. Par « jonction thermoélectrique », aussi appelée jonction NP, on entend un ensemble comportant deux éléments (premier élément 101 et second élément 102 au sens de la présente description) reliés électriquement entre eux. Les premier et second éléments 101, 102 de la jonction thermoélectrique 103 forment un couple de premier et second éléments 101, 102 notamment formés en matériaux à coefficient Seebeck de signes opposés. En particulier, les premier et second éléments 101, 102 sont à base d'un, ou sont formés en, matériau, notamment semi-conducteur, de type P (c'est-à-dire à coefficient Seebeck positif et différent de 0 : le coefficient Seebeck est donc strictement positif pour le matériau de type P) ou de type N (c'est-à-dire à coefficient Seebeck négatif et différent de 0 : le coefficient Seebeck est donc strictement négatif pour le matériau de type N). Selon une autre formulation, les premier et second éléments 101, 102 sont notamment formés dans des, ou sont à base de, matériaux thermoélectriques différents. On dit aussi que le premier élément 101 peut comporter un premier matériau et que le second élément 102 peut comporter un deuxième matériau différent du premier matériau, ces premier et deuxième matériaux étant des matériaux thermoélectriques. Les premier et second éléments d'une jonction thermoélectrique sont aussi appelés dans le domaine de la thermoélectricité plots de la jonction thermoélectrique 103. De préférence, les premier et second éléments 101, 102 sont chacun en matériau dopé de type N ou de type P formant alors le matériau thermoélectrique correspondant, de tels matériaux sont tout particulièrement compatibles avec les techniques de la microélectronique. Le matériau dopé de type N ou de type P peut être à base de semi-conducteur, par exemple choisi parmi le silicium (Si), le silicium-germanium (SiGe), un semi-conducteur polycristallin, et un semi-conducteur nanostructuré ou non. Par « semi-conducteur nanostructuré », on entend par exemple sous la forme de super-réseaux ou de super-réseaux de boîtes quantiques. Notamment, chaque premier élément 101, ceci étant aussi valable pour chaque second élément 102, appartient à une unique jonction thermoélectrique 103, en particulier ceci s'applique pour une pluralité de jonctions thermoélectriques reliées électriquement en série. Lorsque plusieurs jonctions thermoélectriques 103 sont présentes au sein d'un même dispositif thermoélectrique 100, elles sont préférentiellement reliées électriquement en série et thermiquement en parallèle. Le dopage est ici un dopage électrique, le dopant de type N pouvant être du phosphore et le dopant de type P pouvant être du bore.

Par « proximale », on entend le plus proche, et par « distale » on entend le plus éloigné.

Par « substrat », on entend un support physique réalisé à base d'un matériau adapté. Le substrat 108 sert de support à la formation de la, ou des, jonctions thermoélectriques 103. Le substrat 108 permet dans le cadre du dispositif thermoélectrique 100 de maintenir la cohérence de ce qui constitue tout ou partie du dispositif thermoélectrique 100. Selon les réalisations décrites ci-après, le substrat 108 peut être une tranche (« wafer » en langue anglaise) de semi-conducteur ou une plaque de verre. Typiquement, le substrat 108 peut être en verre ou en matériau semi-conducteur comme par exemple le silicium, ou à base de verre ou de matériau semi-conducteur. L'épaisseur e du substrat 108 peut être comprise entre 100µm et 3mm, ou entre 100µm et 1mm, ces gammes d'épaisseur sont tout particulièrement adaptées pour un dispositif thermoélectrique 100 réalisé à partir de techniques de la microélectronique. Le substrat 108 en verre est préféré car le verre est un meilleur isolant thermique par rapport au substrat 108 en matériau semi-conducteur. Plus le substrat 108 est isolant thermiquement, plus la différence de température de part et d'autre du substrat 108 peut être importante lors du fonctionnement du dispositif thermoélectrique que cela soit en mode Peltier ou en mode Seebeck car cela limite les échanges thermiques de part et d'autre du substrat 108.

Par « à base de » on entend « comporte majoritairement », ou « est constitué par ».

Par « sensiblement orthogonale », on entend « orthogonale » ou « orthogonale à plus ou moins 10% ». Par « sensiblement parallèle », on entend « parallèle » ou « parallèle à plus ou moins 10% ».

Comme illustré en figures 2 à 5, la couche formant le premier élément 101 peut présenter un profil, pris selon une section dudit premier élément 101 sensiblement orthogonale à la direction donnant l'épaisseur du substrat 108, annulaire. Plus généralement, le premier élément 101 de la jonction thermoélectrique 103 est préférentiellement creux, et le second élément 102 de la jonction thermoélectrique 103 est préférentiellement entouré par le premier élément 101. Le premier élément 101 peut donc comporter une cavité lui conférant sa forme de corps creux délimitant ainsi un volume interne du premier élément 101, et le second élément 102 est alors placé dans la cavité du premier élément 101. La cavité du premier élément 101 relie ses première et deuxième extrémités, cette cavité est ouverte aux première et deuxième extrémités du premier élément 101, et est fermée entre les première et deuxième extrémités du premier élément 101. En ce sens, la cavité du premier élément 101 peut être délimitée par un trou débouchant dudit premier élément 101. Le fait que le premier élément 101 soit creux permet avantageusement de maximiser l'aire de la section du premier élément 101 en vue de limiter la valeur de la résistance interne $R_{int}$ (équation

(1)). Par ailleurs, structurellement, on comprend que lorsque le second élément 102 est entouré par le premier élément 101, notamment de telle sorte qu'il y est inséré/logé, ceci permet une meilleure intégration de la jonction thermoélectrique 103 correspondante au sein du dispositif thermoélectrique 100 en limitant le volume qu'elle y occupe.

Selon une réalisation illustrée en figures 2 et 3, le second élément 102 de la jonction thermoélectrique 103 est plein : il adopte la forme d'un corps plein. Ceci a pour objectif d'améliorer la résistance interne $R_{int}$ du dispositif thermoélectrique 100.

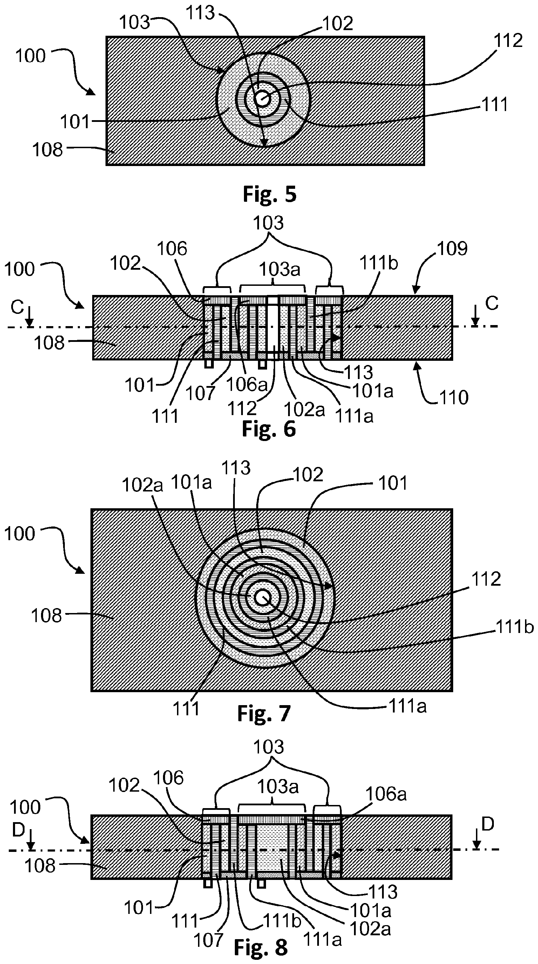

Selon une autre réalisation illustrée en figures 4 et 5, le second élément 102 de la jonction thermoélectrique 103 est creux, il peut alors, comme le premier élément 101, adopter la forme d'une couche présentant un profil, pris selon une section dudit second élément 102 sensiblement orthogonale à la direction donnant l'épaisseur du substrat 108, annulaire. La couche formant le second élément 102 peut présenter (en particulier lorsqu'elle est en polysilicium dopé) une épaisseur comprise entre 200nm et 5$\mu$m, de préférence comprise entre 1$\mu$m et 5$\mu$m, et par exemple égale à 2$\mu$m. L'épaisseur de la couche formant le second élément 102 est préférentiellement mesurée sensiblement orthogonalement à la direction de mesure de l'épaisseur du substrat 108, cette épaisseur de ladite couche est choisie pour limiter les coûts et pour que le second élément 102 ne soit pas trop résistif électriquement parlant. L'avantage associé à un tel second élément 102 creux est qu'il peut permettre de loger au moins une autre jonction thermoélectrique en vue d'augmenter la densité de jonctions thermoélectriques au sein du dispositif thermoélectrique 100, et/ou qu'il peut permettre la formation d'un passage 112 (figures 4 et 5), aussi appelé « ouverture traversante » au travers du substrat 108 selon son épaisseur, ce passage 112 est destiné à recevoir une piste électriquement conductrice permettant, par exemple, de former une liaison électrique traversant le substrat 108. Le second élément 102 peut donc comporter une cavité lui conférant sa forme de corps creux. La cavité du second élément 102 relie ses première et deuxième extrémités, cette cavité est ouverte aux première et deuxième extrémités du second élément 102, et est fermée entre les première et deuxième extrémités du second élément 102. En ce sens, la cavité du second élément 102 peut être délimitée par un trou débouchant dudit second élément 102. Ainsi, en considérant la jonction thermoélectrique 103, les premier et second éléments 101, 102 peuvent être des corps creux délimitant chacun un volume interne, le second élément 102 étant placé dans le volume interne du premier élément 101. Cette réalisation présente l'avantage de pouvoir former les premier et second éléments 101, 102 d'une même jonction thermoélectrique 103 au plus proche l'un de l'autre, il en résulte la possibilité d'obtenir une densité élevée de jonctions thermoélectriques au sein du dispositif thermoélectrique 100, par exemple en insérant/emboîtant les jonctions thermoélectriques les unes dans les autres comme il le sera vu par la suite. Le fait de conserver un passage 112 permet de combiner la fonction thermoélectrique du dispositif thermoélectrique 100 à des empilements en trois dimensions de puces ou dispositifs électroniques à relier électriquement par la liaison électrique passant par le passage 112.

Par « densité », on entend une quantité de jonctions thermoélectriques par unité de surface, ou plus particulièrement de volume, au sein du dispositif thermoélectrique 100.

Le premier élément 101 et éventuellement le second élément 102 peuvent être formés chacun par un cylindre creux comportant une paroi interne et une paroi externe. La distance séparant la paroi interne de la paroi externe délimite l'épaisseur de la couche formant le premier ou second élément 101, 102 correspondant. Les parois externe et interne sont reliées notamment par les première et deuxième extrémités du premier ou second élément 101, 102 concerné. Ainsi, préférentiellement, les premier et second éléments 101, 102 de la jonction thermoélectrique 103 se présentent chacun sous la forme d'une couche de sorte à délimiter deux cylindres creux (formant respectivement le premier élément 101 et le second élément 102) coaxiaux et d'axes sensiblement parallèles à la direction de mesure de l'épaisseur du substrat 108, ceci permettant une bonne intégration de la jonction thermoélectrique dans le substrat tout en autorisant soit la formation du passage 112 soit d'une autre jonction thermoélectrique dans le volume interne du cylindre creux associé au second élément 102 de la jonction thermoélectrique 103.

Selon les deux réalisations illustrées aux figures 2 à 5, le substrat 108 est préférentiellement muni d'un trou débouchant 113 reliant les première et deuxième faces 109, 110 du substrat 108. Au moins les premier et second éléments 101, 102 de la jonction thermoélectrique 103 sont alors agencés dans ledit trou débouchant 113. Ainsi, les premier et second éléments 101, 102 peuvent présenter chacun une dimension dite « hauteur », selon l'épaisseur du substrat 108, comprise entre 100$\mu$m et 3mm. De préférence, la jonction thermoélectrique 103 est agencée dans ledit trou débouchant 113. En ce sens, le substrat 108 présente l'avantage de servir de support à la jonction thermoélectrique 103, tout en permettant à la jonction thermoélectrique 103 d'être intercalée entre un premier côté 104 du dispositif thermoélectrique 100 et un deuxième côté 105 du dispositif thermoélectrique 100. En figures 2 et 4, le premier côté 104 est situé du côté de la première face 109, et le deuxième côté 105 est formé du côté de la deuxième face 110. Dans un substrat 108 en matériau semi-conducteur, le trou débouchant 113 peut être formé à partir de techniques de lithographie et de gravure. Dans un substrat 108 en verre, le trou débouchant peut être obtenu par forage au laser (« laser drilling » en langue anglaise), ou par photolithographie suivie d'une gravure humide à base d'acide fluorhydrique (HF), ou par photolithographie suivie d'une gravure plasma (par exemple de type ICP-RIE avec comme

précurseurs $SF_6$ ou $C_4F_8$, ICP-RIE correspondant à « inductively coupled plasma reactive ion etching » en langue anglaise). Le diamètre, ou dimension latérale maximale du trou débouchant 113, mesuré orthogonalement à l'épaisseur du substrat 108, peut être comprise entre $1\mu m$ et $100\mu m$ pour le substrat en matériau semiconducteur, et peut être compris entre $30\mu m$ et 1mm pour le substrat en verre. De préférence, le diamètre, ou dimension maximale latérale du trou débouchant 113, mesuré orthogonalement à l'épaisseur du substrat 108, est comprise entre $30\mu m$ et $100\mu m$. Ces dimensions sont tout particulièrement adaptées pour permettre le logement d'une ou plusieurs jonctions thermoélectriques au sein d'un même trou débouchant 113 comme il le sera décrit plus en détails ci-après. Le diamètre ou dimension maximale latérale, du trou débouchant 113 dans le cadre du substrat en verre est généralement plus important que dans le cadre du substrat en matériau semi-conducteur du fait de la technique utilisée pour l'obtenir. Ainsi, si un tel trou débouchant 113 dans le substrat en verre était comblé pour former un seul élément (premier élément ou second élément) de jonction thermoélectrique, cela se ferait au détriment de l'intégration de la jonction thermoélectrique au sein du dispositif thermoélectrique qui occuperait une place importante. Ainsi, le fait d'utiliser un trou débouchant 113 du substrat, en particulier en verre, pour y intégrer les premier et second éléments 101, 102 d'une même jonction thermoélectrique 103 permet de limiter la place occupée par ces premier et second éléments 101, 102 en comparaison la formation de ces premier et second éléments 101, 102 dans deux trous distincts. Le trou débouchant 113 adopte préférentiellement une forme cylindrique, ceci permettant de simplifier les reprises de contact électrique entre les choses à lier électriquement au niveau dudit, ou dans ledit, trou débouchant 113. La forme du trou cylindrique correspond notamment à une forme générale du trou débouchant, cependant sa forme peut être légèrement conique du fait des techniques de gravure utilisées pour le former.

Le dispositif thermoélectrique 100 peut être tel que les premier et second éléments 101, 102 de la jonction thermoélectrique 103 sont reliés électriquement entre eux à leurs extrémités proximales du premier côté 104. Le premier côté 104 peut être un côté dit chaud du dispositif thermoélectrique 100 alors que le deuxième côté 105 peut être un côté dit froid du dispositif thermoélectrique 100. Alternativement, le côté froid peut correspondre au premier côté 104 et le côté chaud peut correspondre au deuxième côté 105. Dès lors, la jonction thermoélectrique 103 peut être agencée entre le premier côté 104 et le deuxième côté 105 de telle sorte que, en fonctionnement du dispositif thermoélectrique 100, il est généré un effet thermoélectrique à partir de la jonction thermoélectrique 103. Notamment, l'effet thermoélectrique lie un flux de chaleur traversant la jonction thermoélectrique à un courant électrique traversant la jonction thermoélectrique. Le flux de chaleur est dépendant d'une différence de température présente de part et d'autre du substrat 108.

L'effet thermoélectrique peut être un effet Peltier : dans ce cas un courant électrique circulant dans le dispositif thermoélectrique 100 permet de générer un déplacement de chaleur permettant d'échauffer le premier côté 104 du dispositif thermoélectrique 100 et de refroidir le deuxième côté 105 du dispositif thermoélectrique 100 en utilisant la jonction thermoélectrique. On dit aussi que dans ce cas le dispositif thermoélectrique 100 est générateur d'énergie thermique.

L'effet thermoélectrique peut être un effet Seebeck : dans ce cas une différence de température appliquée au dispositif thermoélectrique 100 de part et d'autre du substrat 108, notamment entre le premier côté 104 et le deuxième côté 105, permet de générer une énergie électrique, notamment une tension, à partir de la, c'est-à-dire issue au moins en partie de la, jonction thermoélectrique 103. On dit aussi que dans ce cas le dispositif thermoélectrique 100 est générateur d'énergie électrique.

On comprend de ce qui a été décrit ci-dessus que la, ou les, jonctions thermoélectriques sont configurées pour générer l'effet thermoélectrique recherché lors du fonctionnement du module thermoélectrique. La ou les jonctions thermoélectriques permettant :

- la génération d'une énergie thermique (différence de température entre les premier et deuxième côtés 104, 105) lorsqu'elles sont soumises à une énergie électrique alimentant lesdites jonctions thermoélectriques : il s'agit de l'effet Peltier,
- la génération d'une énergie électrique lorsqu'elles sont soumises à une différence de température appliquée au dispositif thermoélectrique 100, notamment entre ses premier et deuxième côtés 104, 105 : il s'agit de l'effet Seebeck.

En particulier, la couche formant le premier élément 101 de la jonction thermoélectrique 103 peut s'étendre contre une paroi du trou débouchant 113. Le premier élément 101 peut alors être en contact avec la paroi du trou débouchant 113. Le cas échéant, notamment si le substrat 108 est électriquement conducteur, le substrat 108 peut présenter en surface une couche en matériau diélectrique délimitant la paroi du trou débouchant 113, cette couche en matériau diélectrique pouvant présenter une épaisseur comprise entre 50nm et $1\mu m$. Cette couche en matériau diélectrique n'est pas nécessaire si le substrat 108 est en verre. Cet agencement particulier permet d'obtenir le premier élément 101 de forme adéquate, par exemple en forme de cylindre creux, vis-à-vis du but recherché d'amélioration de l'intégration de la jonction thermoélectrique 103 au sein du dispositif thermoélectrique 100. La paroi du trou débouchant 113 correspond à la surface de la cavité délimitée par ce trou débouchant 113, et ce quel que soit la section du trou débouchant 113. Cette paroi du trou débouchant 113 peut comporter une face dite surface de révolution ou une pluralité de faces liées entre elles pour délimiter la surface de la paroi du trou débouchant 113.

Un avantage d'utiliser un trou débouchant 113 du substrat 108 pour loger la jonction thermoélectrique 103 est que le dispositif thermoélectrique 100 peut être obtenu avec une maîtrise des coûts selon les techniques de la microélectronique. En effet, la jonction thermoélectrique 103 peut être obtenue par dépôts successifs de matériaux adaptés dans le trou débouchant 113 et éventuellement par traitement de ces derniers (siliciuration). Par ailleurs, la formation d'un trou débouchant 113 au sein d'un substrat 108 est une technique maîtrisée dans la microélectronique, cette technique étant ici adaptée pour obtenir le résultat recherché à savoir, de préférence, que le premier élément 101 entoure le second élément 102 dans le trou débouchant 113 du substrat 108.

Par ailleurs, le dispositif thermoélectrique peut comporter (figures 2 et 4) des parties en siliciure 122a, 122b formées dans le prolongement des premier et second éléments 101, 102 à l'opposé de l'élément de liaison 106 ou de leur liaison électrique. Ces parties en siliciure 122a, 122b peuvent être en siliciure de même nature que celui de l'élément de liaison 106. Le cas échéant, les parties en siliciure 122a, 122b peuvent permettre une reprise de contact électrique efficace pour des bornes de connexion 114, 115 du dispositif thermoélectrique 100. Ces bornes de connexion 114, 115 sont de préférence métalliques, par exemple en un métal choisi parmi : le cuivre, l'aluminium, le nickel, l'or, et une bicouche comprenant une couche de nickel et une couche d'or, les dimensions de ces bornes de connexion seront adaptées en fonction des besoins et contraintes. En cas d'utilisation d'une bicouche nickel/or, la couche en nickel assure le contact avec les parties en siliciure 122a, 122b ou avec les premier et second éléments 101, 102. Selon l'épaisseur du substrat 108, ces parties 122a, 122b en siliciure peuvent présenter chacune une épaisseur comprise entre 10nm et 1$\mu$m. En particulier, ces parties 122a, 122b peuvent appartenir aux premier et second éléments dans le sens où elles peuvent avoir été obtenues par siliciuration des deuxièmes extrémités des premier et second éléments 101, 102.

Il a été évoqué précédemment un matériau diélectrique 111 séparant les premier et second éléments 101, 102 d'une même jonction thermoélectrique 103. Ce matériau diélectrique peut être choisi parmi HTO (pour « High Temperature Oxide » en langue anglaise et correspondant notamment à un oxyde $SiO_2$ déposé), le dioxyde de silicium ($SiO_2$), le nitrure de silicium ($Si_3N_4$), l'oxynitrure de silicium (SiON). Tout matériau diélectrique visé dans la présente description peut être choisi dans la liste de matériau diélectrique donnée ci-dessus. D'autres matériaux adaptés pourront bien entendu être utilisés du moment qu'ils permettent d'isoler électriquement et efficacement les premier et second éléments 101, 102 de la jonction thermoélectrique 103. En particulier, ce matériau diélectrique 111 peut adopter la forme d'une couche formée entre le premier élément 101 et le second élément 102. Cette couche en matériau diélectrique 111 peut présenter une épaisseur comprise entre 50nm et 1$\mu$m. L'épaisseur de la couche en matériau diélectrique 111 est notamment mesurée dans une direction sensiblement orthogonale à la direction donnant l'épaisseur du substrat 108. Le cas échéant, lorsque le premier élément 101 est creux la couche en matériau diélectrique 111 est placée dans le volume interne du premier élément 101.

On comprend des équations (1) à (3) données précédemment que le nombre de jonctions thermoélectriques au sein d'un même dispositif thermoélectrique 100 a une influence sur ses performances. En ce sens, il existe un besoin d'augmenter le nombre de jonctions thermoélectriques qu'il est possible d'avoir au sein d'un même dispositif thermoélectrique. Pour répondre à ce besoin, il est à présent décrit une réalisation particulière telle qu'illustrée à titre d'exemple en figures 6 à 9. En ce sens, le dispositif thermoélectrique 100 peut comporter au moins un ensemble de jonctions thermoélectriques 103, 103a reliés électriquement en série, et, pour cet ensemble de jonctions thermoélectriques, les premiers et seconds éléments 101, 101a, 102, 102a des jonctions thermoélectriques 103, 103a dudit ensemble sont placés les uns dans les autres, ainsi que notamment dans le trou débouchant 113. Ceci permet d'augmenter la densité des jonctions thermoélectriques en insérant les jonctions thermoélectriques 103, 103b de l'ensemble les unes dans les autres : pour un même volume par rapport à la solution de la figure 1 selon l'art antérieur, il est possible d'intégrer plus de jonctions thermoélectriques au sein de ce volume. Selon une autre formulation, le dispositif thermoélectrique 100 comporte (figures 6 à 9) au moins un ensemble de jonctions thermoélectriques 103, 103a reliées électriquement en série et comprenant chacune un premier élément 101, 101a et un second élément 102, 102a (bien entendu ces premier et second éléments sont reliés électriquement entre eux), lesdites jonctions thermoélectriques 103, 103a dudit ensemble étant agencées de telle sorte que :

- l'une des jonctions thermoélectriques dudit ensemble de jonctions thermoélectriques est une première jonction thermoélectrique 103 correspondant à ladite jonction thermoélectrique 103 dont le premier élément 101 adopte la forme d'une couche,
- l'une des jonctions thermoélectriques dudit ensemble de jonctions thermoélectriques (c'est-à-dire une autre des jonctions thermoélectriques dudit ensemble de jonctions thermoélectriques vis-à-vis de la première jonction thermoélectrique 103) est une deuxième jonction thermoélectrique 103a entourée par la première jonction thermoélectrique 103.

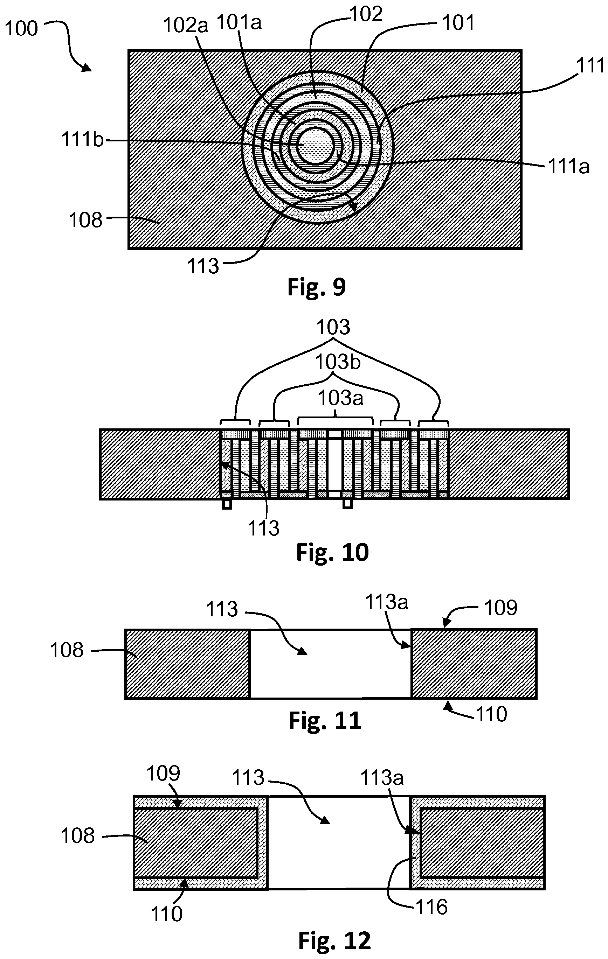

Ainsi les premier et second éléments 101, 102 de la première jonction thermoélectrique 103 sont creux, et les premier et second éléments 101a, 102a de la deuxième jonction thermoélectrique 103a sont placés dans les volumes internes des premier et second éléments 101, 102 de la première jonction thermoélectrique 103. En particulier, les première et deuxième jonctions thermoélectriques 103, 103a sont dites « coaxiales » selon un axe sensiblement orthogonal au plan du substrat 108. La première jonction thermoélectrique 103 est aussi appelée jonction thermoélectrique périphérique de l'ensemble qui la comporte dans le sens où elle entoure chaque autre jonction thermoélectrique dudit ensemble. La deuxième jonction thermoélectrique 103a est aussi appelée jonction thermoélectrique centrale dudit ensemble qui la comporte dans le sens où elle est entourée par chaque autre jonction thermoélectrique dudit ensemble. En particulier, toutes les jonctions thermoélectriques dudit ensemble sont agencées/logées dans un même trou débouchant 113 du substrat 108. Sur ces figures 6 à 9, le matériau diélectrique 111 sépare les premier et second éléments 101, 102 de la première jonction thermoélectrique 103, le matériau diélectrique 111a sépare les premier et second éléments 101a, 102a de la deuxième jonction thermoélectrique 103a. Par ailleurs, un matériau diélectrique tel que celui utilisé pour séparer les premier et second éléments d'une même jonction thermoélectrique peut être utilisé pour séparer les jonctions thermoélectriques entre elles comme le montre la référence 111b relative à ce matériau diélectrique de séparation des jonctions thermoélectriques 103, 103a se présentant, par exemple, sous la forme d'une couche d'épaisseur comprise entre 50nm et 1$\mu$m, cette épaisseur étant mesurée sensiblement orthogonalement à la direction de mesure de l'épaisseur du substrat 108. En figure 6 et 8, les premier et second éléments 101, 102 de la première jonction thermoélectrique 103 sont préférentiellement reliés électriquement par l'élément de liaison 106. En figure 6 et 8, les premier et second éléments 101a, 102a de la deuxième jonction thermoélectrique 103a sont préférentiellement reliés électriquement par l'élément de liaison 106a. Par ailleurs, en figures 6 et 8, les première et deuxième jonctions thermoélectriques 103, 103a sont reliées électriquement entre elles par l'élément de connexion 107. Pour améliorer l'intégration des jonctions thermoélectriques au sein du substrat 108, le second élément 102a de la deuxième jonction thermoélectrique 103a est, de préférence, entouré par le premier élément 101a de la deuxième jonction thermoélectrique 103a. Par ailleurs, le second élément 102a de la deuxième jonction thermoélectrique 103a peut être creux ou plein. Les avantages découlant du fait que le second élément 102a de la deuxième jonction thermoélectrique 103a soit creux ou plein sont les mêmes que ceux décrits ci-dessus en référence avec le second élément 102 des figures 2 à 5. Les figures 6 et 7 représentent une réalisation selon laquelle le second élément 102a est creux de sorte à laisser un passage 112 au travers du substrat 108, c'est-à-dire selon l'épaisseur du substrat 108. Les figures 8 et 9 représentent une réalisation selon laquelle le second élément 102a est plein. De préférence, le dispositif thermoélectrique 100 comporte une pluralité de trous débouchants 113 et une pluralité d'ensembles de jonctions thermoélectriques tels que décrits précédemment, chaque trou débouchant logeant un ensemble correspondant de jonctions thermoélectriques pour augmenter le nombre de jonctions thermoélectriques au sein du dispositif thermoélectrique 100.

Toujours dans le but d'augmenter le nombre de jonctions thermoélectriques au sein du dispositif thermoélectrique 100, et bien entendu le cas échéant si les dimensions du trou débouchant 113 le permettent, l'ensemble de jonctions thermoélectriques peut comporter (figure 10) au moins une, ou plusieurs, troisième(s) jonction(s) thermoélectrique(s) 103b, dite(s) jonction(s) thermoélectrique(s) intercalaire(s). La, et notamment chaque, jonction thermoélectrique 103b intercalaire est intercalée entre la première jonction thermoélectrique 103 et la deuxième jonction thermoélectrique 103a. Autrement dit, la troisième jonction 103b est entourée par la première jonction thermoélectrique 103, et entoure la deuxième jonction thermoélectrique 103a. L'exemple en figure 10 représente une seule jonction thermoélectrique intercalaire 103b, néanmoins, l'homme du métier comprend qu'en fonction de l'espace disponible, il est possible d'en intégrer plus entre les première et deuxième jonctions thermoélectriques 103, 103a.

Selon une réalisation particulière, l'épaisseur de chacun des premier(s) et second(s) éléments 101, 102 formé dans le trou débouchant 113, prise orthogonalement au plan du substrat 108, peut varier en fonction de la position du premier ou second élément concerné entre la paroi du trou débouchant 113 et le centre du trou débouchant 113 de sorte à conserver une résistance électrique identique, ou similaire, pour chacun des premier(s) et second(s) éléments 101, 102. Ceci n'est pas obligatoire mais permet d'améliorer le dispositif thermoélectrique lors de son fonctionnement par conservation d'une aire A (voir équation (1)) à peu près constante pour tous les premier(s) et second(s) éléments. Notamment, plus le premier ou second élément 101, 102 est proche du centre du trou 113 plus son épaisseur augmente en particulier pour pallier à la réduction de son diamètre extérieur.

En particulier, lorsque le passage 112 est présent, il est agencé au travers du substrat 108, notamment selon son épaisseur, et ce passage 112 est entouré par les premier et second éléments 101, 102 de la jonction thermoélectrique 103, et notamment de chaque jonction thermoélectrique de l'ensemble de jonctions thermoélectriques insérées les unes dans les autres. On dit aussi que le passage 112 traverse le substrat 108 et que le passage 112 est séparé dudit substrat 108 par au moins une jonction thermoélectrique 103, Les avantages liés à la présence du passage 112 ont déjà été décrits précédemment.

Il est à présent décrit un procédé de fabrication du dispositif thermoélectrique 100, notamment tel que décrit dans la présente description. Un tel procédé de fabrication comporte une étape de fourniture (figure 11) du substrat 108, et une étape de formation de ladite au moins une jonction thermoélectrique (figure 12 à 19) telle que le premier élément 101 de la jonction thermoélectrique 103 adopte la forme d'une couche. L'avantage de la formation d'une telle couche découle de ce qui a été décrit précédemment, cela permet notamment d'améliorer l'intégration de la jonction thermoélectrique 103 au sein du dispositif thermoélectrique 100, et notamment du substrat 108.

Notamment (figure 11), le substrat 108 fourni comporte le trou 113, notamment débouchant, dont la paroi 113a, aussi appelée paroi interne, est reliée à la première face 109 du substrat 108. La jonction thermoélectrique 103 est formée à partir dudit trou 113, notamment dans ledit trou 113. Le trou débouchant 113 a pu être obtenu de la manière décrite précédemment.

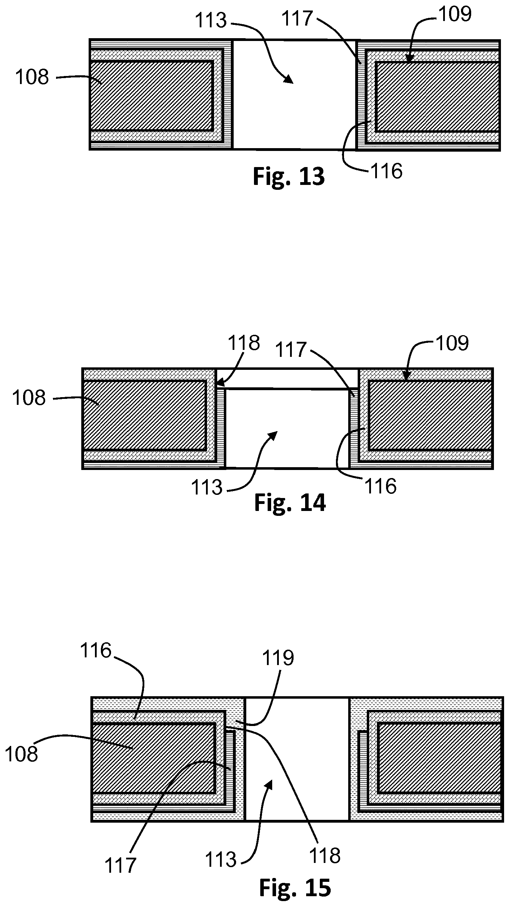

Selon une première réalisation du procédé de fabrication, le substrat 108 fourni est tel que le trou 113 est un trou débouchant dont la paroi 113a relie la première face 109 du substrat 108 à la deuxième face 110 du substrat 108 (figure 11). L'étape de formation de ladite au moins une jonction thermoélectrique 103 peut comporter une étape de formation d'une première couche 116 en un premier matériau (figure 12). Cette première couche 116 s'étend au moins dans le trou débouchant 113 pour former, dans le trou débouchant 113, le premier élément 101 de la jonction thermoélectrique 103. Le premier matériau peut être du polysilicium dopé de type N (dans ce cas le dopant peut être du phosphore), ou en un autre matériau thermoélectrique tel que visé précédemment. L'épaisseur de la première couche 116 déposée peut être comprise entre 200nm et 5$\mu$m, préférentiellement entre 1$\mu$m et 5$\mu$m, et peut être préférentiellement égale à 2$\mu$m. L'étape de dépôt de la première couche 116 peut être un dépôt conforme notamment tel que la première couche 116 peut s'étendre à l'extérieur du trou débouchant 113, par exemple sur les première et deuxième faces 109, 110 du substrat 108 et sur la paroi 113a du trou débouchant 113 pour la toute première des premières couches 116 (figure 12) si plusieurs doivent en être déposées comme il le sera vu par la suite. Ensuite, l'étape de formation de ladite au moins une jonction thermoélectrique peut comporter (figure 13) une étape de formation d'une deuxième couche 117 en matériau diélectrique à partir de la première couche 116, par exemple par oxydation de cette première couche 116 ou par dépôt du matériau diélectrique sur la première couche 116. Cette deuxième couche 117 est destinée à former le matériau diélectrique 111. L'oxydation de la première couche 116 peut être réalisée quand le matériau composant ladite première couche 116 s'y prête, notamment lorsque ce matériau est à base de silicium. Le dépôt de la deuxième couche 117 peut être réalisé par un dépôt de diélectrique adapté (par exemple oxyde, nitrure, SiON ou HTO). Cette deuxième couche 117 peut présenter une épaisseur comprise entre 50nm et 1$\mu$m, et notamment égale à 200nm. Le matériau diélectrique peut être choisi dans la liste décrite précédemment. Cette deuxième couche 117 peut couvrir la première couche 116 comme l'illustre la figure 13. Ainsi, la deuxième couche 117 s'étend au moins dans le trou débouchant 113. Ensuite (figure 14), l'étape de formation de ladite au moins une jonction thermoélectrique peut comporter une étape de gravure de la deuxième couche 117 de sorte à en retirer une portion située dans le trou débouchant 113, libérant ainsi une portion 118 de la première couche 116, cette portion 118 étant située dans le trou débouchant 113. Cette gravure, notamment gravure sèche, de la deuxième couche 117 est orientée vers la première face 109 du substrat 108 d'où il résulte le passage de la figure 13 à la figure 14. Une telle gravure de la deuxième couche 117 permet notamment de retirer le matériau diélectrique, issu de la deuxième couche 117, déposé du côté de la première face 109 du substrat 108 et de poursuivre son retrait selon une profondeur, par exemple comprise entre 10nm et 1$\mu$m, dans le trou débouchant 113 pour libérer la portion 118 en vue de permettre ultérieurement la formation de l'élément de liaison 106. Une telle gravure de la deuxième couche 117 permet d'éviter une étape supplémentaire de photolithographie. Cette gravure sert notamment à permettre par la suite d'assurer la continuité électrique entre les premier et second éléments 101, 102 de la jonction thermoélectrique 103. Ensuite, comme illustré en figure 15, l'étape de formation de ladite au moins une jonction thermoélectrique peut comporter une étape de dépôt d'un deuxième matériau au moins dans le trou débouchant 113, par exemple sous la forme d'une troisième couche 119. Le deuxième matériau déposé forme, dans le trou débouchant 113, le second élément 102 de la jonction thermoélectrique 103. Le deuxième matériau peut être du polysilicium dopé de type P (dans ce cas le dopant peut être du bore), ou en un autre matériau thermoélectrique tel que visé précédemment. L'épaisseur de la troisième couche 119 peut être comprise entre 200nm et 5$\mu$m, préférentiellement entre 1$\mu$m et 5$\mu$m, et peut être préférentiellement égale à 2$\mu$m. Par ailleurs, notamment dans le trou débouchant 113, le deuxième matériau déposé est en contact, d'une part, avec la deuxième couche 117 et, d'autre part, avec la portion 118 de la première couche 116. Le contact du deuxième matériau avec la portion 118 permet d'assurer la continuité électrique entre les premier et second éléments 101, 102 de la jonction thermoélectrique 103 et le contact avec la deuxième couche 117 permet d'assurer une isolation électrique entre les premier et second éléments 101, 102. Le cas échéant, cette troisième couche 119 peut être déposée de sorte à former une couche hors du trou débouchant 113, et à combler, ou non, le trou débouchant 113. Lorsque le deuxième matériau déposé ne comble pas le trou 113, il forme une couche dans ledit trou débouchant 113 et cela permet soit de prévoir le passage 112 évoqué précédemment, soit de réaliser une autre jonction thermoélectrique. Notamment, les premier et deuxième matériaux décrits en relation avec cette première réalisation sont des matériaux thermoélectriques et sont à coefficient Seebeck de signe opposé (l'un étant strictement positif et l'autre étant strictement négatif).

Les étapes de formation de la première couche 116, de la deuxième couche 117, et de dépôt du deuxième matériau sont préférentiellement réalisées de manière conforme. Ceci permet d'assurer un remplissage maitrisé du trou débouchant 113 pour y former différents constituants de la jonction thermoélectrique 103. En particulier, si le premier matériau et le deuxième matériau sont en polysilicium dopé (le cas échéant de type P ou de type N), l'étape de formation de la première couche 116 et de dépôt du deuxième matériau peuvent être réalisées par LPCVD (pour « Low Pressure Chemical Vapor Déposition » en langue anglaise) ou par CVD (pour « Chemical Vapor Déposition » en langue anglaise). Si le premier matériau et le deuxième matériau permettent de former des super-réseaux, les étapes de formation de la première couche 116 et de dépôt du deuxième matériau peuvent être réalisées par RPCVD (pour « Reduced Pressure Chemical Vapor Déposition » en langue anglaise). Si le matériau diélectrique de la deuxième couche 117 est un HTO, sa formation peut être mise en œuvre par LPCVD.

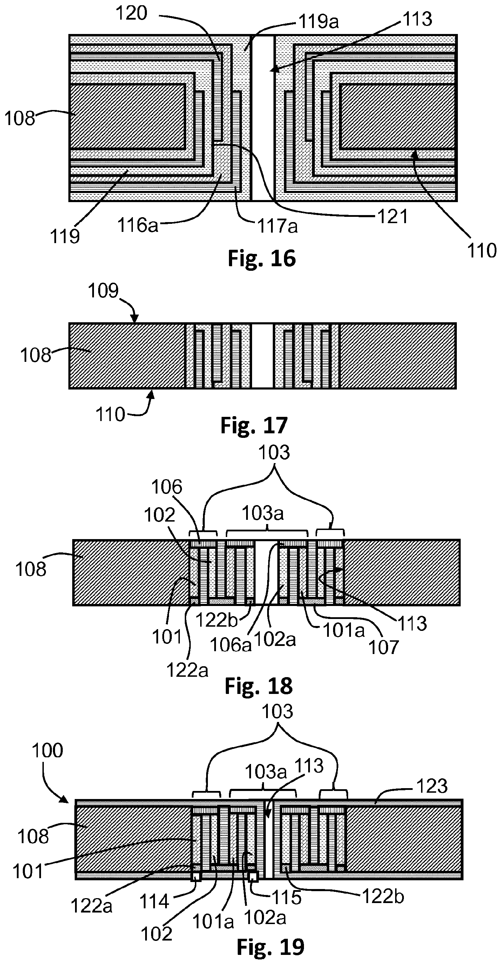

Les étapes de formation de la première couche 116, de la deuxième couche 117, et de dépôt du deuxième matériau peuvent être mise en œuvre pour toute jonction thermoélectrique à former dans le trou débouchant 113, notamment dans l'épaisseur du substrat 108. Autrement dit, ces trois étapes peuvent être itérées pour chaque jonction thermoélectrique à former dans le trou débouchant 113 lorsque plusieurs jonctions thermoélectriques sont à former dans le trou débouchant 113. C'est en substance ce qui est illustré en figure 16 où l'on visualise une autre première couche 116a, une autre deuxième couche 117a et une autre troisième couche 119a formées à la manière de ce qui a été décrit précédemment. Sur la figure 16, une couche de séparation 120 en matériau diélectrique est agencée entre la troisième couche 119 et la première couche 116a pour isoler électriquement le second élément d'une jonction thermoélectrique du premier élément d'une autre jonction thermoélectrique (on forme ainsi le matériau diélectrique référencé 111b décrit précédemment). En fait, chaque couche de séparation 120 peut être en matériau diélectrique tel que décrit précédemment et déposée de manière conforme. Avant de former la première couche 116a représentée en figure 16 sur la couche de séparation 120, la couche de séparation 120 est gravée du côté de la deuxième face 110 du substrat 108 de sorte à libérer une portion 121 de la troisième couche 119. Cette portion 121 est située dans le trou débouchant 113, et est destinée à venir en contact avec la première couche 116a de l'autre jonction thermoélectrique en vue de réaliser la liaison électrique en série de deux jonctions thermoélectriques.

Après formations de toutes les premières couches et dépôts du deuxième matériau dans le trou débouchant 113, le procédé de fabrication peut comporter une étape de retrait de matière des deux côtés du substrat 108 jusqu'aux première et deuxième faces 109, 110 du substrat 108 comme illustré en figure 17. Ceci peut être mis en œuvre par CMP (pour « Chemical Mechanical Planarization » en langue anglaise). Pour faciliter ce retrait par CMP, le substrat 108 peut comporter en surface une couche d'arrêt comme par exemple du nitrure de silicium (non représentée). Alternativement à la CMP, il peut être réalisé un polissage uniquement mécanique comme par exemple de type « fine grinding » ou « dry polish » en langue anglaise. Le retrait de matière des deux côtés du substrat 108 est notamment tel que chacune des couches formées et chacun des matériaux déposés, et s'étendant initialement au moins dans le trou débouchant 113 ne s'étend plus que dans le trou débouchant 113. Ensuite (figure 18), de part et d'autre du substrat 108, le premier et le deuxième matériau présent dans le trou débouchant 113 subissent préférentiellement, lorsqu'ils comportent du silicium, une siliciuration selon une profondeur déterminée, par exemple entre 10nm et 1$\mu$m, pour former, le cas échant l'élément de liaison électrique 106, 106a entre les premier et second éléments 101, 102, 102a de chaque jonction thermoélectrique 103, 103a présente dans le trou débouchant 113, l'élément de connexion électrique 107 entre tout couple de jonctions thermoélectriques adjacentes présentes dans le trou débouchant 113, et les parties 122a, 122b en siliciure pour recevoir les bornes de connexion 114, 115 représentées en figure 19. Par « ordre de » pour une valeur, on entend cette valeur à plus ou moins 10%. La siliciuration permet d'améliorer les contacts électriques entre les premier et second éléments d'une même jonction thermoélectrique et/ou entre les jonctions thermoélectriques et/ou entre les premier et second éléments concernés et les bornes de connexion 114, 115. La siliciuration peut être mise en œuvre à partir d'un dépôt, notamment de chaque côté du substrat 108, d'une bicouche par exemple de 50nm d'épaisseur (par exemple cette bicouche comporte une couche de TiN notamment de 10nm d'épaisseur et une couche de Ti notamment de 40nm d'épaisseur) et en contact avec les matériaux à transformer localement en siliciure. Chaque bicouche utilisée pour la siliciuration peut comporter la couche de titane en contact avec les premier et deuxième matériaux présents dans le trou débouchant 113 le cas échant du côté de la première face 109 du substrat 108 ou du côté de la deuxième face 110 du substrat 108, et la couche de nitrure de titane (TiN) en contact avec la couche de titane. Après dépôt de la ou des bicouches pour la siliciuration, une étape de recuit est réalisée, par exemple à une température comprise entre 400°C et 800°C pour obtenir le siliciure souhaité, et plus particulièrement entre 700°C et 800°C pour obtenir du siliciure de titane. En fait, cette gamme de température de 400°C à 800°C donne des températures qui seront choisies par l'homme du métier en fonction du siliciure à obtenir. En particulier, cette étape de recuit permet de faire réagir le titane avec le silicium contenu dans les premier et deuxième matériaux pour former des portions/parties en siliciure notamment aux

extrémités opposées de chacun des premier(s) et second(s) éléments 101, 102, 102a. Une gravure chimique est ensuite mise en œuvre pour retirer le nitrure de titane, et le titane n'ayant pas réagi avec le premier matériau et le deuxième matériau issus du trou débouchant 113. En figure 19, après siliciuration, une formation d'une couche de protection 123 en matériau diélectrique peut venir revêtir le dispositif thermoélectrique 100 en surface. Enfin, les bornes de connexion 114, 115 visibles en figure 19 peuvent être formées par des étapes de photolithographie et de gravure de la couche de protection 123 pour former des ouvertures révélant des zones de reprise de contact issues des parties 122a, 122b en siliciure, puis par dépôt de métal adapté sur ces zones de reprise de contact.

Dans l'exemple illustré en figure 19, le trou débouchant 113 du substrat 108 n'est pas totalement rebouché mais comporte les jonctions thermoélectriques 103 et 103a. Bien entendu, il peut l'être en adaptant les épaisseurs des couches déposées, et obtenir le cas échéant un dispositif thermoélectrique du type de celui illustré en figure 8.

Selon cette première réalisation, le substrat 108 est préférentiellement un substrat en verre, par exemple d'épaisseur de $300\mu m$ et dans lequel le trou débouchant 113 présente un diamètre de $20\mu m$. L'avantage du substrat en verre est sa très faible conductivité thermique permettant d'améliorer le gradient thermique aux bornes de la, ou de chacune des, jonctions thermoélectriques.

Bien entendu, selon cette première réalisation le substrat 108 peut comporter une pluralité de trous débouchants 113 dans chacun desquels est formée au moins une jonction thermoélectrique à la manière de ce qui a été décrit ci-dessus.

Selon une deuxième réalisation particulière du procédé de fabrication ayant pour but de diminuer les coûts, le substrat 108 est en un matériau présentant un premier coefficient Seebeck. Par ailleurs, l'étape de formation de ladite au moins une jonction thermoélectrique 103 est telle que l'un des premier et second éléments 101, 102 de la jonction thermoélectrique 103 est formé par une partie du substrat 108, et l'autre des premier et second éléments 101, 102 de la jonction thermoélectrique 103 est formé par un deuxième matériau présentant un deuxième coefficient Seebeck de signe opposé au premier coefficient Seebeck, le deuxième matériau étant déposé dans une cavité formée dans le substrat 108. L'avantage de cette deuxième réalisation du procédé de fabrication est de réduire le coût et la durée de fabrication du dispositif thermoélectrique 100 en utilisant au moins une partie du substrat 108 pour former l'un des premier et second éléments 101, 102 de la jonction thermoélectrique 103. De manière générale, en appliquant cette deuxième réalisation au dispositif thermoélectrique 100, on dit que le substrat 108 est dopé électriquement d'un type choisi entre P ou N, et que l'un des premier et second éléments 101, 102 est dans un matériau identique à celui du substrat 108, notamment ce matériau identique à celui du substrat est issu du substrat 108.

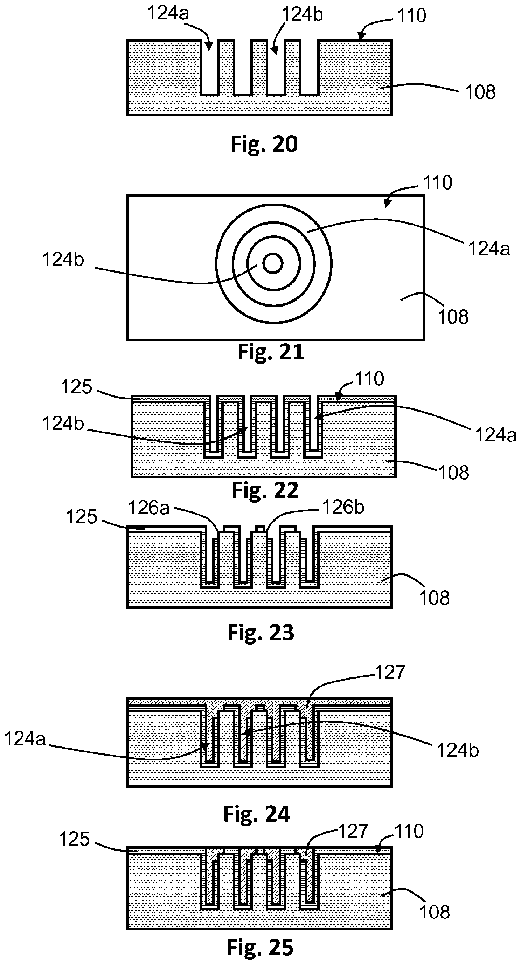

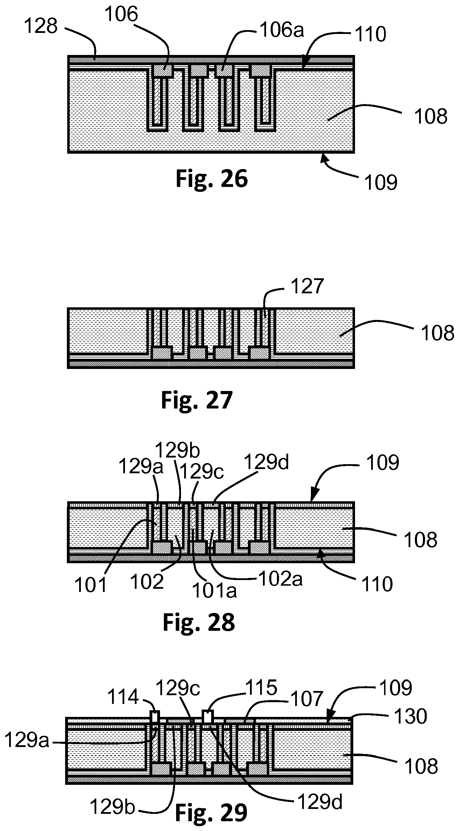

Selon un exemple particulier de cette deuxième réalisation du procédé de fabrication permettant de former deux jonctions thermoélectriques reliées en série, il est d'abord fourni un substrat 108 (figures 20 et 21, la figure 21 étant une vue de dessus du substrat de la figure 20) dans lequel sont formées deux tranchées circulaires 124a, 124b. Ces tranchées 124a, 124b circulaires sont notamment formées dans la deuxième face 110 du substrat 108, et présentent notamment chacune une section, prise dans le plan du substrat, en forme d'anneau. Ces tranchées sont notamment réalisées de telle manière que le volume des tranchées est strictement inférieur au volume occupé par ladite partie du substrat pour adapter sa résistance au dopage plus faible que celui du deuxième matériau déposé. Par exemple, si le substrat 108 est dix fois plus résistif que le deuxième matériau qui va être déposé, la tranchée sera dix fois plus petite que l'espace entre les tranchées pour obtenir des résistances électriques du même ordre de grandeur pour les différents premier(s) et second(s) éléments 101, 102. Ensuite, il est formé (figure 22) en surface du substrat 108, depuis sa deuxième face 110, une couche en matériau diélectrique 125 par exemple d'épaisseur comprise entre 50nm et 500nm. Cette couche en matériau diélectrique 125 couvre alors la deuxième face 110 du substrat 108 ainsi que des flancs et le fond de chaque tranchée 124a, 124b. Les tranchées 124a, 124b peuvent présenter une largeur comprise entre $1\mu m$ et $10\mu m$, et notamment égale à $6\mu m$. Les tranchées 124a, 124b peuvent présenter une profondeur comprise entre $50\mu m$ et $300\mu m$, et notamment égale à $200\mu m$. Ensuite, comme illustré en figure 23, des portions de la couche en matériau diélectrique 125 sont retirées (par exemple par photolithographie suivie d'une gravure sèche) au niveau des sommets de certains flancs pour libérer des portions 126a, 126b du substrat 108 en vue de permettre la connexion électrique entre les premier et second éléments d'une même jonction thermoélectrique. Ensuite, un dépôt du deuxième matériau 127, vient combler les tranchées 124a, 124b (figure 24). Pour passer de la figure 24 à la figure 25, une étape de CMP orientée vers la deuxième face 110 du substrat 108 avec un arrêt sur la couche en matériau diélectrique 125 permet de retirer un éventuel surplus de deuxième matériau 127 déposé hors des tranchées et au-dessus de la couche en matériau diélectrique 125. En figure 26, il est formé des éléments de liaison 106, 106a en siliciure par siliciuration de portions de premier matériau et de deuxième matériau situées du côté de la deuxième face 110 du substrat 108, notamment selon une profondeur, donnée selon l'épaisseur du substrat 108, comprise entre 10nm et $1\mu m$, ou entre 50nm et 200nm. Ces éléments de liaison 106, 106a ont une forme annulaire et relient électriquement les premier et second éléments d'une même jonction thermoélectrique. La siliciuration peut ici être obtenue en utilisant une bicouche pour la siliciuration telle que décrite précédemment. Une couche de protection 128, notamment en matériau diélectrique et d'épaisseur comprise entre 500nm et 2μm, est ensuite formée pour protéger le dispositif thermoélectrique du côté des éléments de liaison 106, 106a. En figure 27, le substrat 108 est retourné, et est aminci depuis sa deuxième face 109 (figure 26) pour atteindre le deuxième matériau 127. Après avoir révélé le deuxième matériau 127, une étape de siliciuration (figure 28) permet de former des éléments en siliciure référencés 129a, 129b, 129c, 129d à la première face 109 du substrat 108 opposée à la deuxième face 110 du substrat 108, notamment par siliciuration partielle des premiers et seconds éléments 101, 102, 102a. En figure 28, on voit aussi que le substrat 108 s'est partiellement transformé en siliciure à sa première face 109. Ces éléments en siliciure 129a, 129b, 129c, 129d peuvent présenter chacun, selon l'épaisseur du substrat, une épaisseur comprise entre 10nm et 1μm, ou entre 50nm et 200nm. Ces éléments en siliciure 129a, 129b, 129c, 129d peuvent être obtenus par l'utilisation d'une bicouche pour la siliciuration telle que décrite précédemment. Pour finir des bornes de connexion 114, 115 notamment métalliques telles que décrites précédemment et un élément de connexion 107 entre jonctions thermoélectriques sont formés (figure 29) après ouverture d'une couche en matériau diélectrique 130 déposée du côté de la première face 109 du substrat 108. L'élément de connexion 107 est en contact avec les éléments en siliciure 129b, 129c, la borne de connexion 114 est en contact avec l'élément en siliciure 129a, et la borne de connexion 115 est en contact avec l'élément en siliciure 129d.

Les tranchées selon la deuxième réalisation peuvent être obtenues selon les enseignements du document « Via First Technology Devlopment Based on High Aspect Ratio Trenches Filled with Doped Polysilicon » de D. Henry et al. publié par IEEE dans « Electronic Components and Technology Conférence » en 2007 en pages 830 à 835.

Selon une variante de cette deuxième réalisation du procédé de fabrication, le deuxième matériau peut être un métal permettant de former des jonctions semi-conducteur/métal lorsque le substrat est à base de semi-conducteur. Cette variante permet une réalisation technologique simplifiée. D'un point de vue puissance électrique générée, le remplacement du matériau thermoélectrique dopé par un métal va diminuer la tension générée par le dispositif thermoélectrique en mode générateur d'électricité (car les métaux ont des coefficients Seebeck faibles), mais la résistance interne sera également beaucoup plus faible (car les métaux ont des résistivités électriques plus faibles que les semi-conducteurs).

La deuxième réalisation du procédé de fabrication peut être adaptée pour former, si on le souhaite, le passage 112 évoqué précédemment permettant de traverser le substrat 108.

On comprend de ce qui a été décrit ci-dessus que le procédé de fabrication décrit peut être réalisé à partir de techniques de la microélectronique permettant de former des vias traversants par exemple de type TSV (pour Through Silicon Via » en langue anglaise) ou de type TGV (pour « Through Glass Via » en langue anglaise) et en modifiant ces techniques pour former des jonctions thermoélectriques notamment insérées les unes dans les autres.

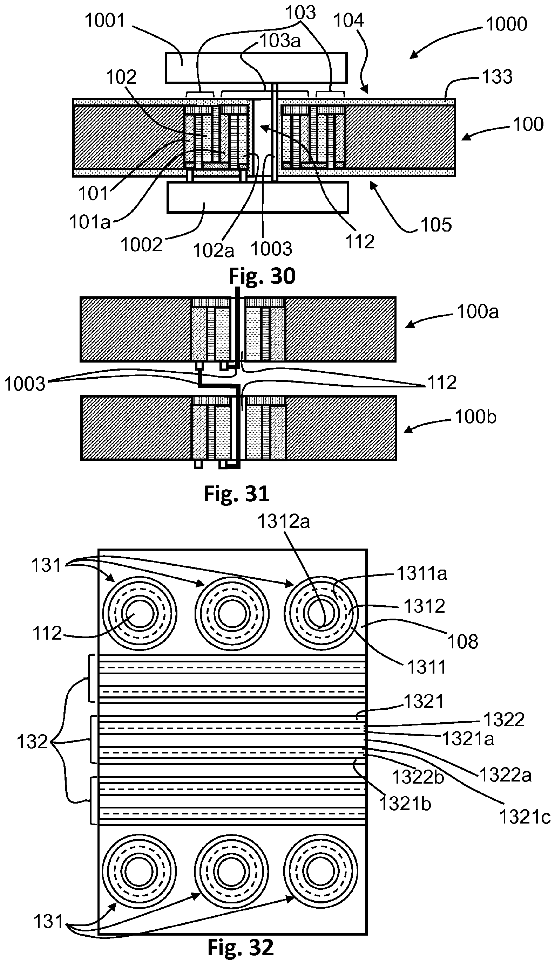

Comme illustré en figure 30, l'invention est aussi relative à un dispositif de génération 1000 d'une première énergie comportant au moins un dispositif thermoélectrique 100 tel que décrit dans la présente description, le dispositif thermoélectrique 100 étant configuré de sorte à exploiter une deuxième énergie pour générer la première énergie, notamment par sa ou ses jonctions thermoélectriques. Grâce à l'utilisation d'un dispositif thermoélectrique 100 tel que décrit dans le cadre de la présente invention, l'efficience du dispositif de génération 1000 de la première énergie est améliorée. Par exemple, la première énergie est une énergie électrique lorsque la deuxième énergie est une énergie thermique (une différence de température) à laquelle le dispositif thermoélectrique 100 est soumis. Par exemple, la première énergie est une énergie thermique lorsque la deuxième énergie est une énergie électrique alimentant le dispositif thermoélectrique 100.

En particulier, en figure 30, le dispositif 1000 de génération de la première énergie peut comporter un premier dispositif électronique 1001 et un deuxième dispositif électronique 1002. Le dispositif thermoélectrique 100 est placé entre les premier et deuxième dispositifs électroniques 1001, 1002 de telle sorte que le premier dispositif électronique 1001 forme une source chaude pour le dispositif thermoélectrique 100. Notamment, le premier dispositif électronique 1001 est adjacent au premier côté 104 du dispositif thermoélectrique 100, et le deuxième dispositif électronique 1002 est adjacent au deuxième côté 105 du dispositif thermoélectrique 100, ce deuxième côté 105 formant un côté source froide du dispositif thermoélectrique 100. Cette source froide correspond par exemple à la température de l'environnement du côté du deuxième côté 105. Le dispositif thermoélectrique 100 comporte le passage 112 entouré par les premier(s) et second(s) éléments 101, 101a, 102, 102a de la ou des jonctions thermoélectriques 103, 103a. Le passage 112 est agencé au travers du substrat 108 (notamment selon son épaisseur) ou plus généralement au travers du dispositif thermoélectrique 100, et au moins un lien électrique 1003 (comme par exemple un fil ou une piste) relie électriquement le premier dispositif électronique 1001 au deuxième dispositif électronique 1002 en passant par le passage 112. Notamment, le premier dispositif électronique 1001 émet plus de chaleur que le deuxième dispositif électronique 1002. Notamment, le premier dispositif électronique 1001 peut être par exemple une diode électroluminescente, ou un composant électronique de puissance (par exemple un convertisseur), ou une puce logique, et le deuxième dispositif électronique 1002 peut être un capteur, ou une mémoire, produisant notamment peu de chaleur et dont le fonctionnement peut être perturbé par la chaleur. Bien entendu, ces exemples de premier et deuxième dispositifs électroniques 1001, 1002 ne sont pas limitatifs. En figure 30, une couche de protection en matériau diélectrique 133 recouvre au moins en partie le dispositif thermoélectrique 100. On comprend alors qu'en figure 30, le dispositif thermoélectrique est à effet Seebeck : sa ou ses jonctions thermoélectriques génèrent une énergie électrique en exploitant la différence de température à laquelle le dispositif thermoélectrique est soumis entre la source chaude et la source froide.

Il est aussi possible de réaliser des empilements de dispositifs thermoélectriques 100a, 100b tels que décrits et reliés électriquement entre eux à la manière de ce qui est illustré en figure 31 en exploitant les passages 112 par exemple traversés chacun par un lien électrique 1003. En figure 31, l'un des liens électriques 1003 permet notamment de relier en série deux dispositifs thermoélectriques 100a, 100b.

Selon une réalisation, le dispositif thermoélectrique peut comporter des jonctions thermoélectriques formées par des couches planaires de sorte que les premiers et seconds éléments sont des couches planaires préférentiellement formées dans le substrat.

La figure 32 illustre à titre d'exemple l'intégration de plusieurs ensembles de jonctions thermoélectriques dans un substrat 108. Ainsi, six premiers ensembles 131 sont formés dans des trous débouchants, à sections circulaires, du substrat 108 tout en laissant des passages 112 au travers du substrat 108. Concernant ces premiers ensembles 131, les lignes en pointillé représentent une séparation entre deux jonctions thermoélectriques reliées électriquement en série du premier ensemble concerné. Les premiers ensembles 131 de jonctions thermoélectriques sont formés chacun par des couches successives agencées en travers de l'épaisseur du substrat 108. Pour chaque premier ensemble 131, il est représenté deux jonctions thermoélectriques reliées électriquement en série et comprenant respectivement un premier couple de premier et second éléments 1311, 1312 et un deuxième couple de premier et second éléments 1311a, 1312a. Par ailleurs, la figure 32 illustre aussi trois deuxièmes ensembles 132 de jonctions thermoélectriques formés chacun par des couches successives agencées en travers de l'épaisseur du substrat 108. En particulier, chaque couche successive de chacun des premiers ensembles 131 peut être formée simultanément, notamment par dépôt, avec au moins une des couches de chacun des deuxièmes ensembles 132. Ainsi, les premiers et deuxièmes ensembles 131, 132 peuvent être formés au moins en partie simultanément. Chacun des deuxièmes ensembles 132 comporte deux couples de jonctions thermoélectriques tels qu'au sein d'un couple de jonctions thermoélectriques lesdites jonctions thermoélectriques sont reliées en série, et que les deux couples de jonctions thermoélectriques sont reliés en parallèle. Sur la figure 32, cela se traduit par le fait que chaque deuxième ensemble 132 comporte :

- un premier couple de jonctions thermoélectriques comportant :

  ◦ des premier et second éléments 1321, 1322 appartenant à l'une des jonctions thermoélectriques dudit premier couple de jonctions thermoélectriques, et
  ◦ des premier et second éléments 1321a, 1322a appartenant à l'autre des jonctions thermoélectriques dudit premier couple de jonctions thermoélectriques,

- un deuxième couple de jonctions thermoélectriques comportant :

  ◦ des premier et second éléments 1321b, 1322b formant l'une des jonctions thermoélectriques dudit deuxième couple de jonctions thermoélectriques, et
  ◦ des premier et second éléments 1321c, 1322a formant l'autre des jonctions thermoélectriques dudit deuxième couple,

et par le fait que les premiers éléments 1321 et 1321b sont reliées à des bornes de connexion d'entrée dudit deuxième ensemble 132, et par le fait que le second élément 1322a est commun à deux jonctions thermoélectriques et est relié à une borne de connexion de sortie dudit deuxième ensemble 132. Les trois deuxièmes ensembles 132 peuvent avoir été obtenus chacun depuis d'un trou débouchant de section rectangulaire formé dans le substrat 108 avant de venir découper le substrat 108 de sorte à former une succession de couches « planaires » en travers du plan du substrat. Concernant ces deuxièmes ensembles 132, les lignes en pointillé représentent chacune une séparation entre deux jonctions thermoélectriques reliées électriquement en série du deuxième ensemble concerné. Pour faciliter la lecture de cette figure 32, en vue de dessus, les éléments de liaison ainsi que les matériaux diélectriques évoqués ci-avant n'ont pas été représentés pour permettre de visualiser directement les premiers et seconds éléments.

Le dispositif thermoélectrique tel que décrit présente une application industrielle dans tout domaine technique cherchant par exemple à récupérer de l'énergie électrique à partir d'une différence de température disponible générant un gradient thermique aux bornes de la, ou de chacune des, jonctions thermoélectriques. En particulier, le dispositif thermoélectrique tel que décrit peut être utilisé de sorte à servir d'alimentation électrique pour capteur(s) autonome(s), pour composants microélectroniques, pour téléphone mobile, pour un actionneur domotique, pour capteur(s) d'un bâtiment intelligent, pour composant(s) situé(s) dans un réseau électrique intelligent aussi connu sous la dénomination anglaise « smart grid », ou encore dans le domaine de l'Internet des Objets (IoT pour « Internet of Things » en langue anglaise). En fait, lorsque le dispositif thermoélectrique est à effet Seebeck, c'est-à-dire à génération d'énergie électrique, il peut être utilisé pour servir d'alimentation électrique à tout composant, par exemple autonome et non relié à un réseau de distribution d'électricité, en exploitant une différence de température à laquelle il est soumis.

**Revendications**

1. Dispositif thermoélectrique (100) comportant :

   - un substrat (108) comportant des première et deuxième faces (109, 110) opposées selon une épaisseur (e) dudit substrat (108),
   - au moins une jonction thermoélectrique (103) comportant un premier élément (101) et un second élément (102) reliés électriquement entre eux en vue de générer un effet thermoélectrique,

   les premier et second éléments (101, 102) étant agencés dans le substrat (108) et étant reliés électriquement à leurs extrémités situées du côté de la première face (109) du substrat (108), le premier élément (101) adoptant la forme d'une couche, **caractérisé en ce qu'**il comporte au moins un ensemble de jonctions thermoélectriques (103, 103a) reliées électriquement en série et comprenant chacune un premier élément (101, 101a) et un second élément (102, 102a), lesdites jonctions thermoélectriques (103, 103a) dudit ensemble étant agencées de telle sorte que :

   - l'une des jonctions thermoélectriques dudit ensemble est une première jonction thermoélectrique (103) correspondant à ladite jonction thermoélectrique (103) dont le premier élément (101) adopte la forme d'une couche,
   - l'une des jonctions thermoélectriques dudit ensemble est une deuxième jonction thermoélectrique (103a) entourée par la première jonction thermoélectrique (103).

2. Dispositif thermoélectrique (100) selon la revendication précédente, **caractérisé en ce que** le premier élément (101) de la première jonction thermoélectrique (103) est creux, et **en ce que** le second élément (102) de la première jonction thermoélectrique (103) est entouré par le premier élément (101) de la première jonction thermoélectrique (103).

3. Dispositif thermoélectrique (100) selon la revendication précédente, **caractérisé en ce que** le second élément (102) de la première jonction thermoélectrique (103) est creux.

4. Dispositif thermoélectrique (100) selon l'une quelconque des revendications précédentes, **caractérisé en ce que** la première jonction thermoélectrique (103) est formée au travers du substrat (108) selon son épaisseur.

5. Dispositif thermoélectrique (100) selon l'une quelconque des revendications précédentes, **caractérisé en ce que** le substrat (108) est muni d'un trou débouchant (113) reliant les première et deuxième faces (109, 110) du substrat (108), au moins les premier et second éléments (101, 102) de la première jonction thermoélectrique (103) étant agencés dans ledit trou débouchant (113).

6. Dispositif thermoélectrique (100) selon la revendication précédente, **caractérisé en ce que** la couche formant le premier élément (101) de la première jonction thermoélectrique (103) s'étend contre une paroi du trou débouchant (113).

7. Dispositif thermoélectrique (100) selon l'une quelconque des revendications précédentes, **caractérisé en ce que** le substrat (108) est dopé électriquement d'un type choisi entre P ou N, et **en ce que** l'un des premier et second éléments (101, 102) de la première jonction thermoélectrique (103) est dans un matériau identique à celui du substrat (108).

8. Dispositif thermoélectrique (100) selon l'une quelconque des revendications précédentes, caractérisé en que le second élément (102a) de la deuxième jonction thermoélectrique (103a) est entouré par le premier élément (101a) de la deuxième jonction thermoélectrique (103a).

9. Dispositif thermoélectrique (100) selon l'une quelconque des revendications précédentes, **caractérisé en ce que** l'ensemble de jonctions thermoélectriques comporte au moins une troisième jonction thermoélectrique (103b), la troisième jonction thermoélectrique (103b) étant entourée par la première jonction thermoélectrique (103), et la troisième jonction thermoélectrique (103b) entourant la deuxième jonction thermoélectrique (103a).

10. Dispositif thermoélectrique (100) selon l'une quelconque des revendications précédentes, **caractérisé en ce qu'**il comporte un passage (112) agencé au travers du substrat (108) et entouré par les premier et second éléments (101, 102) de la première jonction thermoélectrique (103).

11. Dispositif thermoélectrique (100) selon l'une quelconque des revendications précédentes, **caractérisé en ce que** les premier et second éléments (101, 102) de la première jonction thermoélectrique (103) se présentent chacun sous la forme d'une couche de sorte à délimiter deux cylindres creux coaxiaux et d'axes sensiblement parallèles à la direction de mesure de l'épaisseur du substrat (108).

12. Dispositif de génération (1000) d'une première énergie comportant au moins un dispositif thermoélectrique (100) selon l'une quelconque des revendications précédentes, le dispositif thermoélectrique (100) étant configuré de sorte à exploiter une deuxième énergie pour générer la première énergie.

13. Dispositif de génération (1000) de la première énergie selon la revendication précédente, **caractérisé en ce qu'**il comporte un premier dispositif électronique (1001) et un deuxième dispositif électronique (1002), le dispositif thermoélectrique (100) étant placé entre les premier et deuxième dispositifs électroniques (1001, 1002) de telle sorte que le premier dispositif électronique (1001) forme une source chaude pour le dispositif thermoélectrique (100), et **en ce que** le dispositif thermoélectrique (100) comporte un passage (112) entouré par les premier et second éléments (101, 102) de la première jonction thermoélectrique (103), le passage (112) étant agencé au travers du substrat (108), au moins un lien électrique (1003) reliant électriquement le premier dispositif électronique (1001) au deuxième dispositif électronique (1002) en passant par le passage (112).

14. Procédé de fabrication d'un dispositif thermoélectrique (100) selon la revendication 1, ledit procédé de fabrication comportant :

    - une étape de fourniture du substrat (108), et
    - une étape de formation de ladite au moins une jonction thermoélectrique (103), l'étape de formation de ladite au moins une jonction thermoélectrique étant telle que le premier élément (101) de la jonction thermoélectrique (103) adopte la forme d'une couche,

    le substrat (108) fourni comportant un trou débouchant (113) ayant une paroi (113a) reliant la première face (109) du substrat (108) à la deuxième face (110) du substrat (108), et l'étape de formation de ladite au moins une jonction thermoélectrique (103, 103a) comportant :

    - une étape de formation d'une première couche (116, 116a) en un premier matériau, la première couche (116, 116a) s'étendant au moins dans le trou débouchant (113) pour former, dans le trou débouchant (113), le premier élément (101, 101a) de la jonction thermoélectrique (103, 103a),
    - une étape de formation d'une deuxième couche (117, 117a) en matériau diélectrique à partir de la première couche (116, 116a), la deuxième couche (117, 117a) s'étendant au moins dans le trou débouchant (113),
    - une étape de gravure de la deuxième couche (117, 117a) sorte à en retirer une portion située dans le trou débouchant (113) pour libérer une portion (118) de la première couche (116),
    - une étape de dépôt d'un deuxième matériau, au moins dans le trou débouchant (113), de telle sorte que :

        ◦ le deuxième matériau déposé forme, dans le trou débouchant (113), le second élément (102, 102a) de la jonction thermoélectrique (103, 103a),
        ◦ le deuxième matériau déposé est en contact, d'une part, avec la deuxième couche (117) et, d'autre part, avec la portion (118) de la première couche (116).

**Patentansprüche**

1. Thermoelektrische Vorrichtung (100), welche aufweist:

    - ein Substrat (108), das eine erste und eine zweite Fläche (109, 110) aufweist, die sich in Richtung einer Dicke (e) des Substrats (108) gegenüberliegen,
    - wenigstens einen thermoelektrischen Übergang (103), der ein erstes Element (101) und ein zweites Element (102) aufweist, die zum Erzeugen eines thermoelektrischen Effekts miteinander elektrisch verbunden sind,

    wobei das erste und das zweite Element (101, 102) in dem Substrat (108) angeordnet sind und an ihren Enden, die sich auf der Seite der ersten Fläche (109) des Substrats (108) befinden, elektrisch verbunden sind, wobei das erste Element (101) die Form einer Schicht annimmt, **dadurch gekennzeichnet, dass** sie wenigstens eine Anordnung von thermoelektrischen Übergängen (103, 103a) aufweist, die elektrisch in Reihe verbunden sind und jeweils ein erstes Element (101, 101a) und ein zweites Element (102, 102a) umfassen, wobei die thermoelektrischen Übergänge (103, 103a) der Anordnung derart angeordnet sind, dass:

    - einer der thermoelektrischen Übergänge der Anordnung ein erster thermoelektrischer Übergang (103) ist, der dem thermoelektrischen Übergang (103) entspricht, dessen erstes Element (101) die Form einer Schicht annimmt,
    - einer der thermoelektrischen Übergänge der Anordnung ein zweiter thermoelektrischer Übergang (103a) ist, der von dem ersten thermoelektrischen Übergang (103) umgeben ist.

**2.** Thermoelektrische Vorrichtung (100) nach dem vorhergehenden Anspruch, **dadurch gekennzeichnet, dass** das erste Element (101) des ersten thermoelektrischen Übergangs (103) hohl ist, und dadurch, dass das zweite Element (102) des ersten thermoelektrischen Übergangs (103) von dem ersten Element (101) des ersten thermoelektrischen Übergangs (103) umgeben ist.

**3.** Thermoelektrische Vorrichtung (100) nach dem vorhergehenden Anspruch, **dadurch gekennzeichnet, dass** das zweite Element (102) des ersten thermoelektrischen Übergangs (103) hohl ist.

**4.** Thermoelektrische Vorrichtung (100) nach einem der vorhergehenden Ansprüche, **dadurch gekennzeichnet, dass** der erste thermoelektrische Übergang (103) in Dickenrichtung durch das Substrat (108) hindurch ausgebildet ist.

**5.** Thermoelektrische Vorrichtung (100) nach einem der vorhergehenden Ansprüche, **dadurch gekennzeichnet, dass** das Substrat (108) mit einem Durchgangsloch (113) versehen ist, das die erste und die zweite Fläche (109, 110) des Substrats (108) verbindet, wobei wenigstens das erste und das zweite Element (101, 102) des ersten thermoelektrischen Übergangs (103) in dem Durchgangsloch (113) angeordnet sind.

**6.** Thermoelektrische Vorrichtung (100) nach dem vorhergehenden Anspruch, **dadurch gekennzeichnet, dass** sich die Schicht, die das erste Element (101) des ersten thermoelektrischen Übergangs (103) bildet, an einer Wand des Durchgangsloches (113) anliegend erstreckt.

**7.** Thermoelektrische Vorrichtung (100) nach einem der vorhergehenden Ansprüche, **dadurch gekennzeichnet, dass** das Substrat (108) entsprechend einem Dotierungstyp elektrisch dotiert ist, der aus p- und n-Dotierung ausgewählt ist, und dadurch, dass eines von dem ersten und dem zweiten Element (101, 102) des ersten thermoelektrischen Übergangs (103) aus einem Material besteht, das mit demjenigen des Substrats (108) identisch ist.

**8.** Thermoelektrische Vorrichtung (100) nach einem der vorhergehenden Ansprüche, **dadurch gekennzeichnet, dass** das zweite Element (102a) des zweiten thermoelektrischen Übergangs (103a) vom ersten Element (101a) des zweiten thermoelektrischen Übergangs (103a) umgeben ist.

**9.** Thermoelektrische Vorrichtung (100) nach einem der vorhergehenden Ansprüche, **dadurch gekennzeichnet, dass** die Anordnung von thermoelektrischen Übergängen wenigstens einen dritten thermoelektrischen Übergang (103b) aufweist, wobei der dritte thermoelektrische Übergang (103b) vom ersten thermoelektrischen Übergang (103) umgeben ist und der dritte thermoelektrische Übergang (103b) den zweiten thermoelektrischen Übergang (103a) umgibt.

**10.** Thermoelektrische Vorrichtung (100) nach einem der vorhergehenden Ansprüche, **dadurch gekennzeichnet, dass** sie einen Durchlass (112) aufweist, der durch das Substrat (108) hindurch angeordnet ist und von dem ersten und dem zweiten Element (101, 102) des ersten thermoelektrischen Übergangs (103) umgeben ist.

**11.** Thermoelektrische Vorrichtung (100) nach einem der vorhergehenden Ansprüche, **dadurch gekennzeichnet, dass** das erste und das zweite Element (101, 102) des ersten thermoelektrischen Übergangs (103) jeweils die Form einer Schicht aufweisen, derart, dass sie zwei koaxiale Hohlzylinder mit Achsen, die im Wesentlichen parallel zur Messrichtung der Dicke des Substrats (108) sind, begrenzen.

**12.** Vorrichtung zur Erzeugung (1000) einer ersten Energie, welche wenigstens eine thermoelektrische Vorrichtung (100) nach einem der vorhergehenden Ansprüche aufweist, wobei die thermoelektrische Vorrichtung (100) derart gestaltet ist, dass sie eine zweite Energie nutzt, um die erste Energie zu erzeugen.

**13.** Vorrichtung zur Erzeugung (1000) der ersten Energie nach dem vorhergehenden Anspruch, **dadurch gekennzeichnet, dass** sie eine erste elektronische Vorrichtung (1001) und eine zweite elektronische Vorrichtung (1002) aufweist, wobei die thermoelektrische Vorrichtung (100) zwischen der ersten und der zweiten elektronischen Vorrichtung (1001, 1002) derart angeordnet ist, dass die erste elektronische Vorrichtung (1001) eine Wärmequelle für die thermoelektrische Vorrichtung (100) bildet, und dadurch, dass die thermoelektrische Vorrichtung (100) einen Durchlass (112) aufweist, der vom ersten und vom zweiten Element (101, 102) des ersten thermoelektrischen Übergangs (103) umgeben ist, wobei der Durchlass (112) durch das Substrat (108) hindurch angeordnet ist, wobei wenigstens eine elektrische Verbindung (1003) die erste elektronische Vorrichtung (1001) mit der zweiten elektronischen Vorrichtung (1002) verbindet und dabei durch den Durchlass (112) verläuft.

**14.** Verfahren zur Herstellung einer thermoelektrischen Vorrichtung (100) nach Anspruch 1, wobei das Herstellungsverfahren umfasst:

    - einen Schritt der Bereitstellung des Substrats

(108) und

- einen Schritt der Ausbildung des wenigstens einen thermoelektrischen Übergangs (103), wobei der Schritt der Ausbildung des wenigstens einen thermoelektrischen Übergangs derart ausgeführt wird, dass das erste Element (101) des thermoelektrischen Übergangs (103) die Form einer Schicht annimmt,

wobei das bereitgestellte Substrat (108) ein Durchgangsloch (113) mit einer Wand (113a) aufweist, welche die erste Fläche (109) des Substrats (108) mit der zweiten Fläche (110) des Substrats (108) verbindet, und wobei der Schritt der Ausbildung des wenigstens einen thermoelektrischen Übergangs (103, 103a) umfasst:

- einen Schritt der Ausbildung einer ersten Schicht (116, 116a) aus einem ersten Material, wobei sich die erste Schicht (116, 116a) wenigstens in dem Durchgangsloch (113) erstreckt, um in dem Durchgangsloch (113) das erste Element (101, 101a) des thermoelektrischen Übergangs (103, 103a) zu bilden,
- einen Schritt der Ausbildung einer zweiten Schicht (117, 117a) aus dielektrischem Material von der ersten Schicht (116, 116a) aus, wobei sich die zweite Schicht (117, 117a) wenigstens in dem Durchgangsloch (113) erstreckt,
- einen Schritt der Ätzung der zweiten Schicht (117, 117a), um daraus einen im Durchgangsloch (113) befindlichen Abschnitt zu entfernen, um einen Abschnitt (118) der ersten Schicht (116) freizulegen,
- einen Schritt der Ablagerung eines zweiten Materials wenigstens in dem Durchgangsloch (113), derart, dass:

o das abgelagerte zweite Material in dem Durchgangsloch (113) das zweite Element (102, 102a) des thermoelektrischen Übergangs (103, 103a) bildet,
o das abgelagerte zweite Material sich einerseits mit der zweiten Schicht (117) und andererseits mit dem Abschnitt (118) der ersten Schicht (116) in Kontakt befindet.

**Claims**

1. Thermoelectric device (100) comprising:

- a substrate (108) comprising first and second faces (109, 110) that are opposite one another across a thickness (e) of said substrate (108),
- at least one thermoelectric junction (103) comprising a first element (101) and a second element (102) that are electrically connected to one another in order to generate a thermoelectric effect,

the first and second elements (101, 102) being arranged in the substrate (108) and being electrically connected at their ends that are located on the first-face (109) side of the substrate (108), the first element (101) taking the form of a layer, **characterized in that** it comprises at least one set of thermoelectric junctions (103, 103a) that are electrically connected in series and each comprise a first element (101, 101a) and a second element (102, 102a), said thermoelectric junctions (103, 103a) of said set being arranged such that:

- one of the thermoelectric junctions of said set is a first thermoelectric junction (103) corresponding to said thermoelectric junction (103), the first element (101) of which takes the form of a layer,
- one of the thermoelectric junctions of said set is a second thermoelectric junction (103a) surrounded by the first thermoelectric junction (103).

2. Thermoelectric device (100) according to the preceding claim, **characterized in that** the first element (101) of the first thermoelectric junction (103) is hollow, and **in that** the second element (102) of the first thermoelectric junction (103) is surrounded by the first element (101) of the first thermoelectric junction (103).

3. Thermoelectric device (100) according to the preceding claim, **characterized in that** the second element (102) of the first thermoelectric junction (103) is hollow.

4. Thermoelectric device (100) according to any one of the preceding claims, **characterized in that** the first thermoelectric junction (103) is formed through the substrate (108) across its thickness.

5. Thermoelectric device (100) according to any one of the preceding claims, **characterized in that** the substrate (108) is provided with a through-hole (113) that connects the first and second faces (109, 110) of the substrate (108), at least the first and second elements (101, 102) of the first thermoelectric junction (103) being arranged in said through-hole (113).

6. Thermoelectric device (100) according to the preceding claim, **characterized in that** the layer forming the first element (101) of the first thermoelectric junction (103) extends against a wall of the through-hole (113).

7. Thermoelectric device (100) according to any one of the preceding claims, **characterized in that** the substrate (108) is electrically doped with a type selected from P or N, and **in that** one of the first and second elements (101, 102) of the first thermoelectric junction (103) is made of a material identical to that of the substrate (108).

8. Thermoelectric device (100) according to any one of the preceding claims, **characterized in that** the second element (102a) of the second thermoelectric junction (103a) is surrounded by the first element (101a) of the second thermoelectric junction (103a).

9. Thermoelectric device (100) according to any one of the preceding claims, **characterized in that** the set of thermoelectric junctions comprises at least a third thermoelectric junction (103b), the third thermoelectric junction (103b) being surrounded by the first thermoelectric junction (103), and the third thermoelectric junction (103b) surrounding the second thermoelectric junction (103a).

10. Thermoelectric device (100) according to any one of the preceding claims, **characterized in that** it comprises a passage (112) arranged through the substrate (108) and surrounded by the first and second elements (101, 102) of the first thermoelectric junction (103).

11. Thermoelectric device (100) according to any one of the preceding claims, **characterized in that** the first and second elements (101, 102) of the first thermoelectric junction (103) are each in the form of a layer so as to delimit two coaxial hollow cylinders and of axes that are substantially parallel to the direction in which the thickness of the substrate (108) is measured.

12. Device for generating (1000) a first energy comprising at least one thermoelectric device (100) according to any one of the preceding claims, the thermoelectric device (100) being configured so as to use a second energy to generate the first energy.

13. Device for generating (1000) the first energy according to the preceding claim, **characterized in that** it comprises a first electronic device (1001) and a second electronic device (1002), the thermoelectric device (100) being placed between the first and second electronic devices (1001, 1002) such that the first electronic device (1001) forms a heat source for the thermoelectric device (100), and **in that** the thermoelectric device (100) comprises a passage (112) surrounded by the first and second elements (101, 102) of the first thermoelectric junction (103), the passage (112) being arranged through the substrate (108), at least one electrical link (1003) electrically linking the first electronic device (1001) to the second electronic device (1002) by passing through the passage (112).

14. Method for manufacturing a thermoelectric device (100) according to Claim 1, said manufacturing method comprising:

   - a step of providing the substrate (108), and
   - a step of forming said at least one thermoelectric junction (103), the step of forming said at least one thermoelectric junction being such that the first element (101) of the thermoelectric junction (103) takes the form of a layer,

the supplied substrate (108) comprising a through-hole (113) having a wall (113a) that connects the first face (109) of the substrate (108) to the second face (110) of the substrate (108), and the step of forming said at least one thermoelectric junction (103, 103a) comprising:

   - a step of forming a first layer (116, 116a) made of a first material, the first layer (116, 116a) extending at least into the through-hole (113) to form, in the through-hole (113), the first element (101, 101a) of the thermoelectric junction (103, 103a),
   - a step of forming a second layer (117, 117a) made of dielectric material from the first layer (116, 116a), the second layer (117, 117a) extending at least into the through-hole (113),
   - a step of etching the second layer (117, 117a) so as to remove a portion thereof located in the through-hole (113) to free a portion (118) of the first layer (116),
   - a step of depositing a second material, at least in the through-hole (113), such that:

      ∘ the second deposited material forms, in the through-hole (113), the second element (102, 102a) of the thermoelectric junction (103, 103a),
      ∘ the second deposited material is in contact, on the one hand, with the second layer (117) and, on the other hand, with the portion (118) of the first layer (116).

100
103    106    104

H    101

102    105    107

**Fig. 1 (Art Antérieur)**

104

100    111    102    103    106    109

A    A

108    e

105    101
122a    114    113    122b    115
110

**Fig. 2**

100    103    113    102

108

101    111

**Fig. 3**

104

100    113    109
111    112    103    106
B    B

108    e

105    101    102
122a    114    122b    115
110

**Fig. 4**

**Fig. 5**

**Fig. 6**

**Fig. 7**

**Fig. 8**

**Fig. 9**

**Fig. 10**

**Fig. 11**

**Fig. 12**

**Fig. 13**

**Fig. 14**

**Fig. 15**

**Fig. 16**

**Fig. 17**

**Fig. 18**

**Fig. 19**

**Fig. 20**

**Fig. 21**

**Fig. 22**

**Fig. 23**

**Fig. 24**

**Fig. 25**

128  106                106a        110

**Fig. 26**

108

109

127

108

**Fig. 27**

129b
129a  129c    129d        109

108

110
101   102   101a   102a

**Fig. 28**

114  129c    115   107    109
                          130
129a
108

129b  **Fig. 29**  129d

**Fig. 30**

**Fig. 31**

**Fig. 32**

## RÉFÉRENCES CITÉES DANS LA DESCRIPTION

**Documents brevets cités dans la description**

- US 20140021576 A1

- CN 106486593 A

**Littérature non-brevet citée dans la description**

- Via First Technology Devlopment Based on High Aspect Ratio Trenches Filled with Doped Polysilicon. **DE D. HENRY et al.** Electronic Components and Technology Conférence. IEEE, 2007, 830-835